# EUROPEAN PATENT SPECIFICATION

(11) **EP 1 965 417 B1**
(45) Date of publication and mention of the grant of the patent: **06.03.2013**
(21) Application number: 06835087.5
(22) Date of filing: 21.12.2006
(51) Int. Cl.: H01L 21/321, C09G 1/02, C09K 3/14

(54) **POLISHING COMPOSITION AND POLISHING METHOD FOR FORMING COPPER WIRING FOR SEMICONDUCTOR INTEGRATED CIRCUIT**
POLIERZUSAMMENSETZUNG UND POLIERVERFAHREN ZUR FORMUNG EINER KUPFERVERKABELUNG FÜR EINE INTEGRIERTE HALBLEITERSCHALTUNG
COMPOSITION DE POLISSAGE ET PROCÉDÉ DE POLISSAGE SERVANT À FORMER UN CIRCUIT IMPRIMÉ EN CUIVRE POUR UN CIRCUIT INTÉGRÉ À SEMI-CONDUCTEURS

(30) Priority: 21.12.2005 JP 2005368082; 28.04.2006 JP 2006125474; 11.10.2006 JP 2006277585
(43) Date of publication of application: 03.09.2008
(73) Proprietor: Asahi Glass Company, Limited, Chiyoda-ku Tokyo 100-8405 (JP)
(72) Inventor: YOSHIDA, Iori, Chiyoda-ku, Tokyo 1008405 (JP); KAMIYA, Hiroyuki, Chiyoda-ku, Tokyo 1008405 (JP); TAKEMIYA, Satoshi, Chiyoda-ku, Tokyo 1008405 (JP); HAYASHI, Atsushi, Chiyoda-ku, Tokyo 1008405 (JP); NAKAZAWA, Norihito, Chiyoda-ku, Tokyo 1008405 (JP)
(74) Representative: Müller-Boré & Partner Patentanwälte
(86) International application number: PCT/JP2006/325521
(87) International publication number: WO 2007/072918

(56) References cited:
- EP-A- 1 229 093
- EP-A- 1 520 892
- WO-A-2005/031836
- JP-A- 2001 064 631

## Description

### TECHNICAL FIELD

The present invention relates to a polishing composition and a technique for polishing a surface of semiconductor integrated circuit by using the polishing composition.

### BACKGROUND ART

In recent years, to meet needs for high integration of semiconductor integrated circuit, various microfabrication techniques such as reduction of pattern size or increase of the number of wiring layers in a semiconductor element, have been developed.

The increase of the number of wiring layers is to form a new circuit pattern on an existing circuit pattern by using e.g. a lithography, but if there are protrusions or recessed portions present on a surface of the under layer circuit pattern, protrusions and recessed portions are also formed on a surface of the newly formed circuit pattern, these portions depart from the depth of focus of lithography, and thus, wiring patterns can not be formed as they are designed. To cope with this problem, in the design of semiconductor integrated circuit in recent years, it is required to improve the flatness of a surface of each circuit pattern layer with extremely high precision, so that the surface does not affect a surface of a layer formed thereon.

For example, in a damascene method for forming a wiring circuit and flattening the surface of the wiring circuit at the same time, a groove pattern for wiring is formed on the objecting surface of a semiconductor integrated circuit device, and a metal having relatively low resistivity such as aluminum or a copper metal for forming wiring is formed so that it is embedded in the groove. The metal is initially formed as a film on the surface by using a plating method or a sputtering method, and in most cases, the film is polished by a technique called Chemical Mechanical Polishing (hereinafter referred to as CMP), to remove the metal film other than the wiring portion to form a wiring corresponding to the groove. At this time, flattening of the polished surface is achieved at the same time.

In order not to affect flatness of a surface of overlying layer, the flatness of the polished surface is important and the CMP technique is an essential important technique for producing a highly-integrated semiconductor integrated circuit.

However, in CMP that is a method for flattening a surface by polishing, there are problems to be solved, such as a phenomenon called dishing that is a phenomenon that a wiring portion is more deeply removed than the rest of flat surface, or a phenomenon called erosion that is a phenomenon that a plurality of proximate wirings are removed together with surrounding material such as an insulation material, that occurs according to reduction of metal wiring width. With respect to dishing or erosion, many solutions have been proposed, but they are not sufficiently satisfactory yet.

For example, Patent Document 1 describes an invention of polishing solution containing a water-soluble polymer for suppressing erosion, and Patent Document 2 describes an invention of polishing solution containing a heterocyclic compound for suppressing erosion. Further, Patent Document 3 describes a method of suppressing dishing or erosion by using a polishing solution containing phospheric acid ester, and Patent Document 4 describes a method of adjusting polishing reaction with copper by suing a polishing solution containing fatty acid.
Patent Document 1: JP-A-2002-176015
Patent Document 2: JP-A-2002-12854
Patent Document 3: JP-A-2005-167231
Patent Document 4: JP-A-2002-231666

EP-A-1 520 892 discloses a polishing composition containing: a persulfate, a carboxylic acid such as citric acid, oxalic acid, succinic acid, maleic acid, tartaric acid or an alpha-amino acid, a corrosion inhibitor such as BTA and water, said composition having a pH value of 7-12. Said document also discloses a method for producing a copper wiring for a semiconductor integrated circuit, which comprises polishing a copper film for wiring formed on a surface having grooves with said composition.

### DISCLOSURE OF THE INVENTION

### PROBLEMS TO BE SOLVED BY THE INVENTION

It is an object of the present invention to solve the above problems and to provide a technique which realizes surface flattening with high precision in a device using copper as a metal for wiring. Other objects and merits of the present invention will become clear in the following description.

### MEANS FOR SOLVING THE PROBLEMS

The present invention is defined by claims 1 and 12.

### EFFECTS OF THE INVENTION

According to the present invention, it is possible to realize surface flattening with high precision in a case of using copper as a metal for wiring. Accordingly, the present invention enables to obtain a semiconductor integrated circuit having little dishing or erosion and having excellent and flat surface state, and thus, the present invention is extremely useful for multi-layer structure and fine patterning of semiconductor integrated circuits.

### BRIEF DESCRIPTION OF THE DRAWINGS

Figs. 1(a) to 1(c): Schematic cross sectional views of a wafer with a pattern before and after a CMP step in a process of producing copper buried wirings; wherein Fig. 1(a) is a cross sectional view of a semiconductor integrated circuit before polishing, Fig. 1(b) is a cross sectional view of a semiconductor integrated circuit in which dishing is formed by polishing, and Fig. 1(c) is a cross sectional view of a semiconductor integrated circuit after polishing that is ideally polished.
Fig. 2: A schematic cross sectional view of a patterned wafer for explaining erosion.

### EXPLANATION OF NUMERALS

1: Si Substrate
2: Insulation layer
3: Barrier layer
4: Metal wiring layer
6: Copper buried wiring
7: Dishing amount
8: Initial thickness of copper film
9: Initial stepheight of copper film
17: Dishing portion
18: Erosion portion
19: Maximum stepheight
20: Polished portion of global portion

### BEST MODE FOR CARRYING OUT THE INVENTION

The behavior of the polishing composition according to the present invention is described with respect to a case of polishing a copper film on a surface of a semiconductor integrated circuit having a groove for wiring. In the following, explanation will be made with respect to a case of applying the present invention to a semiconductor integrated circuit device having a copper wiring that is a particularly preferred application.

The polishing composition of the present invention contains neutralized carboxylic acid, an oxidizing agent and water, wherein a part of the carboxylic acid is an alicyclic resin acid and the pH value of the polishing composition is from 7.5 to 12. The polishing composition of the present invention may contain other components besides the above components, and preferably contains abrasive particles or a surfactant. The polishing composition of the present invention is characterized by containing an alicyclic resin acid and a carboxylic acid other than alicyclic resin acid.

### ALICYCLIC RESIN ACID

A resin acid is an organic acid (carboxylic acid) present in a state of free or ester in a natural resin, and an alicyclic resin acid is a compound having an alicyclic structure (refer to "Kagaku Daijiten 4" (chemical encyclopedia 4) published by KYORITSU SHUPPAN CO., LTD., the section of "resin acid"). The alicyclic resin acid (A) of the present invention includes a natural resin containing an alicyclic resin acid; a purified resin acid containing as the main component an alicyclic resin acid produced by purifying (e.g. isomerization may occur at the same time) a natural resin; an alicyclic resin acid being a single compound extracted from a natural resin; and a mixture of at least two types of them.

As the purified resin acid, a rosin obtainable from e.g. a pine rosin, a tall oil, or a tall oil rosin may, for example, be mentioned. Particularly, a purified resin acid containing as the main component an alicyclic resin acid such as abietic acid or its isomer, pimaric acid or its isomer or a hydrogenated abietic acid, is preferred and a commercially available rosin can be used as an alicyclic resin acid of the present invention. Further, in such a rosin, the type or the content of a compound contained in the rosin changes depending on the type of natural resin from which the rosin derives. However, any type of rosin can be used so long as it contains an alicyclic resin acid as the main component.

Some commercially available rosin includes a small amount of aliphatic resin acid. Such an aliphatic resin acid is mainly an unsaturated higher fatty acid such as oleic acid or linoleic acid, and its content is usually about 10 mass% based on total resin. These aliphatic resin acids are preferred compounds as an aliphatic carboxylic acid (B-2) to be described later. Accordingly, in a case of producing a polishing composition containing an alicyclic resin acid (A) and an aliphatic carboxylic acid (B-2) to be described later, it is possible to produce a polishing composition of the present invention by using a commercially available rosin containing aliphatic resin acid without using an aliphatic carboxylic acid (B-2) to be described later separately from the rosin. As an alternative, the polishing composition of the present invention may be produced by using a commercially available rosin containing an aliphatic resin acid and further using an aliphatic carboxylic acid (B-2) separately from the rosin.

As the alicyclic resin acid (A) being a single compound, abietic acid; an isomer of abietic acid such as neoabietic acid, parastrinic acid or levopimaric acid; a hydride of abietic acid such as dihydroabietic acid or tetrahydroabietic acid; or a dehydrogened product of abietic acid such as dehydroabietic acid or secodehydroabietic acid. Besides these, pimaric acid, isopimaric acid, sandaracopimaric acid, communic acid or dihydroagathic acid are mentioned.

In the polishing composition of the present invention, at least two types of the above alicyclic resin acid (A) may be contained. A purified resin acid such as a rosin is originally a mixture of at least two types of alicyclic resin acids (each single compound), and it is regarded as a type of alicyclic resin acid (A) in the present invention. Accordingly, in the polishing composition of the present invention, at least two types of rosins may be contained or as an alternative, a rosin and at least one type of alicyclic resin acid that is a single compound, may be contained.

Further, the alicyclic resin acid (A) of the present invention may be a compound having at least one carboxylic group or a mixture containing such a compound, that is a derivative of the above purified resin acid or alicyclic resin acid that is a single compound. As the derivative, besides an alicyclic resin acid extracted from a natural resin, an isomized product, a hydride, a dehydrogened product, a polysulfide, or a modified product obtainable by adding an unsaturated compound (such as an unsaturated carboxylic acid such as maleic anhydride, fumaric acid, acrylic acid or its anhydride) to an unsaturated group of an alicyclic resin acid by Diels-Alder reaction, may, for example, be mentioned. It is preferably at least one type selected from the group consisting of maleic anhydride addition product (maleic acid modified product), a fumaric acid addition product (fumaric acid modified product) an acrylic acid addition product (acrylic acid modified product) and a dehydrogened product. The dehydrogened product includes a compound a part of whose alicycle becomes an aromatic cycle by the dehydrogenation.

### CARBOXYLIC ACID OTHER THAN ALICYCLIC RESIN ACID

The polishing composition of the present invention contains a carboxylic acid other than the alicyclic resin acid (A). Among carboxylic acids contained in the polishing composition of the present invention, a carboxylic acid ("the other part of the carboxylic acid") other than alicyclic resin acid is referred to as "another organic carboxylic acid (B)". Said another organic carboxylic acid (B) may be any compound so long as it has at least one carboxylic group. Said another organic carboxylic acid (B) is preferably a compound having at least two functional groups including a carboxylic group. Hereinafter a compound having at least two functional groups including carboxylic group is referred to as a carboxylic acid (B-1). The carboxylic acid (B-1) is preferably a compound (hereinafter referred to as polycarboxylic acid) having at least two carboxylic groups or a compound (hereinafter referred to as monocarboxylic acid) having one carboxylic group and at least one functional group other than carboxylic group. The polycarboxylic acid may have at least one functional group other than carboxylic groups. Further, as said another organic carboxylic acid (B), an aliphatic carboxylic acid having total at least 11 carbon atoms and having a long-chain hydrocarbon group having at least 8 carbon atoms, is preferably used in combination with the preferred carboxylic acid (B-1). An aliphatic carboxylic acid having total at least 11 carbon atoms and having a long-chain hydrocarbon group having at least 8 carbon atoms and at least one carboxylic group, is hereinafter referred to as aliphatic carboxylic acid (B-2). The aliphatic carboxylic acid (B-2) is preferably an aliphatic carboxylic acid having total at least 11 carbon atoms and having a long-chain hydrocarbon group having at least 10 carbon atoms and at least one carboxylic group. In order to distinguish the aliphatic carboxylic acid (B-2) from the preferred carboxylic acid (B-1), a portion where the aliphatic carboxylic acid (B-2) and the carboxylic acid (B-1) overlap, is regarded as an aliphatic carboxylic acid (B-2) in this specification. For example, a carboxylic acid having at least two functional groups including a carboxylic group, that is included in a category of aliphatic carboxylic acid (B-2) (hereinafter it is also referred to as aliphatic polycarboxylic acid) is designated as an aliphatic carboxylic acid (B-2).

Accordingly, a carboxylic acid in the explanation of the present invention is categorized into an alicyclic resin acid (A) and another organic carboxylic acid (B), and said another organic carboxylic acid (B) in the present invention is categorized into an aliphatic carboxylic acid (B-2), a carboxylic acid (B-1) and an organic carboxylic acid (hereinafter referred to as carboxylic acid (B-3)) other than these carboxylic acids. The total number of carbon atoms (including carbon atoms of carboxylic groups) of said another organic carboxylic acid (B) other than the aliphatic carboxylic acid (B-2), namely total number of carbon atoms in each of carboxylic acid (B-1) and carboxylic acid (B-3), is not particularly limited but it is preferably at most 12, more preferably at most 10. In a case of aliphatic polycarboxylic acid, the total number of its carbon atoms is preferably at most 6. The number of carboxylic groups in such a polycarboxylic acid is preferably from 2 to 3.

A functional group other than carboxylic group in the carboxylic acid (B-1) is preferably amino group, hydroxyl group or thiol group etc. The amino group may be a secondary amino group (imino group) or a tertiary amino group. Further, the functional group may be a heterocyclic group, and is particularly preferably a heterocyclic group (hereinafter it is also referred to as nitrogen-containing heterocyclic group) having a nitrogen atom as a ring-constituting atom. A hydrogen atom may be bonded or not bonded to the nitrogen atom constituting the ring. The nitrogen-containing heterocyclic group is particularly preferably a pyridine ring (namely, quinoline ring) that is a condensed product of a pyridine ring and a benzene ring. A carboxylic group in a carboxylic acid having a heterocyclic group may be bonded to a carbon atom constituting the ring, or may be bonded to a carbon atom other than the ring. A carboxylic group in a carboxylic acid having a pyridine ring or a quinoline ring is preferably bonded to a carbon atom constituting the ring. The number of carbon atoms other than carbon atoms constituting a ring in a carboxylic acid having a pyridine ring or a quinoline ring, is preferably at most 4 including the carbon atoms of carboxylic group.

The carboxylic acid (B-1) is preferably at least one type of carboxylic acid selected from the group consisting of polycarboxylic acid; and a carboxylic acid having at least one type of group selected from the group consisting of a nitrogen-containing heterocyclic group, amino group, hydroxyl group and thiol group, and at least one carboxylic group; and hereinafter this carboxylic acid is referred to as carboxylic acid (B-1a). The polycarboxylic group may have a functional group such as a nitrogen-containing heterocyclic group. More preferably, the carboxylic acid (B-1) is preferably a polycarboxylic group or a monocarboxylic group having a pyridine ring or a quinoline ring, or an aliphatic polycarboxylic acid having at least 6 carbon atoms such as oxalic acid.

A specific carboxylic acid (B-1a) is exemplified in the following (a) to (e).
(a) Carboxylic acid (monocarboxylic acid, polycarboxylic acid) having a nitrogen-containing heterocyclic group: 2-pyridinecarboxylic acid, 3-pyridinecarboxylic acid, 4-pyridinecarboxylic acid, 2,3-pyridinedicarboxylic acid, 2,4-pyridinedicarboxylic acid, 2,5-pyridinedicarboxylic acid, 2,6-pyridinedicarboxylic acid, 3,4-pyridinedicarboxylic acid, 3,5-pyridinedicarboxylic acid, pyrazinecarboxylic acid, 2,3-pyrazinedicarboxylic acid, 2-quinolinecarboxylic acid (quinaldic acid), 3-quinolinecarboxylic acid, 4-quinolinecarboxylic acid or 8-quinolinecarboxylic acid.
(b) Carboxylic acid (such as amino acid) having an amino group: alanine, glycine, proline, phenylalanine.
(c) Carboxylic acid (such as hydroxycarboxylic acid) having a hydroxyl group: lactic acid, malic acid, citric acid, isocitric acid, tartaric acid, glycolic acid, gluconic acid or salicylic acid.
(d) Other polycarboxylic acids: oxalic acid, malonic acid, succinic acid, fumaric acid, maleic acid, oxalacetic acid, glutaric acid, adipic acid, citraconic acid, itaconic acid, diglycolic acid, thiodiglycolic acid or phthalic acid.
(e) Carboxylic acid having a thiol group: thioglycolic acid or thiosalicylic acid.

As the carboxylic acid (B-3), an aliphatic monocarboxylic acid having no long chain-chain hydrocabon group having at least 8 carbon atoms, an aliphatic monocarboxylic acid having less than 10 carbon atoms and having no functional group, or an aromatic monocarboxylic acid having no functional group, is mentioned. In the present invention, the carboxylic acid (B-3) can be appropriately used according to the purpose, but it is usually not an essential component. Here, the polishing composition of the present invention may contain at least two types of each of the carboxylic acid (B-1) and the carboxylic acid (B-3).

The aliphatic carboxylic acid (B-2) is an aliphatic carboxylic acid having total at least 11 carbon atoms and having a long-chain hydrocarbon group having at least 8 carbon atoms and at least one carboxylic group. The aliphatic carboxylic acid (B-2) is preferably an aliphatic carboxylic acid containing no functional group other than carboxylic group and containing from 1 to 3 carboxylic groups. The number of carboxylic groups is particularly preferably 1 or 2. Further, the long chain hydrocarbon group is preferably a hydrocarbon group having a chain of at least 6 continuous carbon atoms having no side chain alkyl group or having one or more alkyl groups each containing at most 2 carbon atoms. The number of continuous carbon atoms in the long-chain hydrocarbon group, namely the number of carbon atoms in the main chain, is preferably from 6 to 30, more preferably from 10 to 22. Further, the number of carbon atoms in the long-chain hydrocarbon group including side chain carbon atoms is preferably at least 8, more preferably from 8 to 26, particularly preferably from 10 to 22. Here, the long-chain hydrocarbon group means a portion other than a carbon atom to which a carboxyl group is connected. The total number of carbon atoms in the aliphatic carboxylic acid (B-2) (including carbon atoms in the carboxylic group) is preferably from 11 to 23, more preferably from 12 to 22.

The long-chain hydrocarbon group may have one or more unsaturated bonds, and is particularly preferably a hydrocarbon group (namely, alkenyl group) containing from 1 to 3 unsaturated double bonds. The carboxylic group is preferably present at the end of a linear hydrocarbon or in the vicinity of the end. Also in an aliphatic polycarboxylic acid having a long-chain hydrocarbon group having one or more unsaturated bonds, at least two carboxylic groups are preferably bonded to the same or different carbon atoms at the end of a linear hydrocarbon or in the vicinity of the end. For example, in alkenylsuccinic acid, carboxylic groups are bonded to two adjacent carbon atoms at the end.

The aliphatic carboxylic acid (B-2) may, for example, be an aliphatic acid such as an unsaturated aliphatic acid such as maleic acid, myristoleic acid, parmistoleic acid, oleic acid, erucic acid, brassidic acid, linolic acid, linolenic acid, arakidonic acid, eicosapentaenoic acid or docosahexaenoic acid, or a saturated aliphatic acid such as lauric acid, myristic acid, palmitinic acid or stearic acid; or an aliphatic polycarboxylic acid. The aliphatic acid is more preferably an unsaturated aliphatic acid having total from 12 to 23 carbon atoms or a saturated aliphatic acid having total from 11 to 17 carbon atoms, particularly preferably an unsaturated aliphatic acid having total from 14 to 22 carbon atoms or a saturated aliphatic acid having total from 12 to 16 carbon atoms. The aliphatic polycarboxylic acid is preferably alkenylsuccinic acid. Alkenylsuccinic acid is a compound similar to succinic acid except that the above-mentioned alkenyl group is bonded to the second carbon atom of succinic acid, and it may, for example, be decenylsuccinic acid, dodecenylsuccinic acid, tetradecenylsuccinic acid, hexadecenylsuccinic acid or octadecenylsuccinic acid. The number of total carbon atoms of the alkenylsuccinic acid is preferably from 14 to 22.

The aliphatic carboxylic acid (B-2) may be the above-mentioned aliphatic resin acid. Some of commercially available rosins containing alicyclic resin acid as the main component contain about from 5 to 20 mass% of aliphatic resin acid containing as the main component an unsaturated aliphatic acid having 18 carbon atoms such as oleic acid, linolic acid or linolenic acid. When such an aliphatic-resin-acid-containing rosin is used, it is possible to produce the polishing composition of the present invention without using the aliphatic carboxylic acid (B-2) separately. Even in this case, when the amount of aliphatic carboxylic acid (B-2) is small in such a commercially available rosin containing aliphatic carboxylic acid (B-2), besides such a rosin, the aliphatic carboxylic acid (B-2) may further be used. Further, the polishing composition of the present invention may be produced by using a desired amount of aliphatic carboxylic acid (B-2) in addition to a rosin containing substantially no aliphatic resin acid.

The aliphatic carboxylic acid (B-2) is preferably an aliphatic monocarboxylic acid having at least one unsaturated group in its long-chain hydrocarbon group portion and alkenylsuccinic acid, particularly preferably oleic acid, linolic acid, linolenic acid or an alkenylsuccinic acid having total from 14 to 22 carbon atoms. Further, it is preferably an aliphatic resin acid (which mainly contains oleic acid, linolic acid or linolenic acid) that is contained with small amount in a commercially available rosin. Here, at least two type of these aliphatic carboxylic acids may be used in combination.

The aliphatic carboxylic acid (B-2) having the above structure is not an essential component in the polishing composition of the present invention, but small amount of it is preferably used in combination with the carboxylic acid (B-1), particularly with the above carboxylic acid (B-1a). The aliphatic carboxylic acid (B-2) is considered to exhibit a surfactant-like function in the polishing composition of the present invention. The reason is considered as follows. When the aliphatic carboxylic acid (B-2) is contained, an effect of increasing solubility or dispersibility of the above alicyclic resin acid (A) to water in the polishing composition of the present invention, or an effect of promoting a function of the alicyclic resin acid (A) for forming a protection film on a surface of copper film, are obtained, whereby dishing amount is more effectively suppressed.

### NEUTRALIZED CARBOXYLIC ACID

The polishing composition of the present invention contains a neutralized carboxylic acid, an oxidizer and water, wherein a part of the carboxylic acid is an alicyclic resin acid (A) and the pH value is within a range of from 7.5 to 12. The neutralized carboxylic acid preferably contains besides the alicyclic resin acid (A) a carboxylic acid (B-1), particularly preferably contains at least three types of carboxylic acids that are the alicyclic resin acid (A), the carboxylic acid (B-1) and an aliphatic carboxylic acid (B-2).

This polishing composition is a basic composition, and thus, these carboxylic acids are considered to be neutralized and ionized in the composition. The carboxylic acids neutralized in the composition is obtained by blending a salt of carboxylic acid with a water-based medium (a liquid medium such as water or a mixture of water and a water-base medium). Further, such a neutralized carboxylic acid is obtainable by blending a carboxylic acid with a water-base medium containing a basic compound and making it react with the basic compound. In a case of carboxylic acid having low solubility to water, it is preferred to blend such a carboxylic acid by using these methods. In a case of carboxylic acid having high solubility to water, it is also possible to blend the carboxylic acid by such another method of dissolving the carboxylic acid in a water-base medium followed by blending a basic compound to neutralize it. The above alicyclic resin acid is a carboxylic acid having relatively low solubility to water, and thus, it is preferably neutralized by using a method of forming a salt followed by blending it with a water-base medium. Further, it is also preferred that the carboxylic acid is made into fine particles by means of e.g. emulsification and dispersed in a water-base medium and is made to react with a basic compound. Another organic carboxylic acid (B) is also preferably formed into a salt, and thereafter, blended in a water-base medium, since a compound can be produced more easily by such a method.

The salt of carboxylic acid is a salt produced by combining the above carboxylic acid and a base, and such a salt is preferably an alkaline metal salt, an ammonium salt or an organic amine salt. Particularly, a potassium salt or an ammonium salt is preferred. The organic amine is preferably an organic amine of low molecular weight having at most 6 carbon atoms, such as an alkylamine, a dialkylamine, a trialkylamine, an alkanolamine, a dialkanolamine or a trialkanolamine.

The salt of the alicyclic resin acid (A) is preferably an alkaline metal salt (particularly potassium salt) of rosin, that is also called as rosin, an ammonium salt of rosin or an organic amine salt of rosin. Further, as the salt of alicyclic resin acid being a single compound, for example, the following salts are mentioned, and a mixture of at least two types of them may also be used: potassium abietate salt, potassium dehydroabietate salt, potassium tetrahydroabietate salt, potassium dihydroabietate salt, potassium pimarate salt, ammonium abietate salt, ammonium dehydroabietate salt, ammonium tetrahydroabietate salt, ammonium dihydroabietate salt, ammonium pimarate salt, an organic amine abietate salt, an organic amine dehydroabietate salt, an organic amine tetrahydroabietate salt, an organic amine dehydroabietate salt or an organic amine pimarate salt.

Here, in the present invention, even in a case of using a salt of the above alicyclic resin acid (A) or a salt of another organic carboxylic acid (B), the mass or the mass percentage of carboxylic acid is represented by the mass or the mass percentage converted to those of carboxylic acid (COOH). Namely, between a case of preparing the polishing composition of the present invention by using a carboxylic acid and a case of preparing it by using a carboxylate, their mass or mass percentage is the same so long as their molar amount that is converted to that of carboxylic acid is the same.

In a polishing composition, an effect of suppressing dishing amount is obtained by containing an alicyclic resin acid (A). The mechanism of obtaining such an effect is not clear, but it is considered that the composition performs some chemical reaction or physical reaction with a surface of copper film of semiconductor integrated circuit at a time of polishing, and functions as a surface protecting agent for forming a protection layer on a surface of the cover film. This surface protection layer is not strong enough to completely prevent polishing of copper film, and in a copper film on a semiconductor integrate circuit substrate, polishing progresses at a convex portion to which a pressure of polishing pad is large, and polishing does not progress at a concave portion at which the pressure is small. By this mechanism, highly smooth polished surface profile is considered to be realized.

The content of the alicyclic resin acid (A) in the polishing composition is preferably from 0.01 to 2 mass%, particularly preferably from 0.03 to 1 mass%. When the content is less than 0.01 mass%, the protection function of the copper film surface is considered to be insufficient, and corrosion and dishing tend to occur during polishing. Further, if the content exceeds 2 mass%, removal rate of copper may decrease. Here, the content in this specification means a mass% based on total amount of polishing composition, and it means a content based on a diluted polishing composition when it is diluted to be used for polishing.

In a polishing composition, the removal rate of copper increases when the polishing composition contains a carboxylic acid (B-1) although its mechanism is unclear.

The carboxylic acid (B-1) is preferably a carboxylic acid (B-1a). Further, the carboxylic acid (B-1a) is preferably a polycarboxylic acid or a monocarboxylic acid that have nitrogen-containing heterocyclic group, or an aliphatic polycarboxylic acid such as oxalic acid, particularly preferably 2-pyridinecarboxylic acid. By using a carboxylic acid having a nitrogen-containing heterocyclic group such as 2-pyridinecarboxylic acid, an effect of increasing removal rate of copper and an effect of preventing addition or residual of e.g. copper complex on a polishing pad, are exhibited.

The total amount of carboxylic acid contained in the polishing composition of the present invention, is preferably from 0.11 to 8 mass% based on the polishing composition. Among these, the amount of another organic carboxylic acid (B) is preferably from 0.1 to 5 mass% based on the polishing composition. If it is less than 0.1 mass%, the removal rate of copper may decrease, and if it exceeds 5 mass%, corrosion or dishing on a copper surface may occur. The total amount of said another organic carboxylic acid (B) except for the aliphatic carboxylic acid (B-2), is preferably the carboxylic acid (B-1). The carboxylic acid (B-1) is at least 0.1 mass% in the polishing composition.

Further, the ratio of alicyclic resin acid (A) based on the total amount of carboxylic acid is preferably from 1 to 50 mass%. Namely, based on the total carboxylic acid, said other organic carboxylic acid (B) is preferably from 50 to 99 mass%. The ratio of alicyclic resin acid (A) based on the total amount of carboxylic acid, is preferably from 3 to 40 mass% that is converted to the ratio of carboxylic acid.

Further, it is not essential that the polishing composition of the present invention contains the above aliphatic carboxylic acid (B-2), but if it contains, it is considered that an effect of increasing solubility or dispersibility of the alicyclic resin acid (A) to water in the polishing composition of the present invention, or an effect of promoting a function of the alicyclic resin acid (A) for forming a protection film on a copper film surface, are obtained, whereby the dishing amount is more efficiently suppressed. The content of the aliphatic carboxylic acid (B-2) is preferably at least 0.001 mass% based on the total amount of polishing composition in order to obtain the above effects. The content of the aliphatic carboxylic acid (B-2) is preferably at most 0.5 mass%, more preferably at most 0.2 mass% based on the total amount of polishing composition since the copper removal rate may decrease if its content is large.

Here, in a case of using an alicyclic resin acid containing an aliphatic carboxylic acid (B-2) such as a rosin containing an aliphatic carboxylic acid (B-2), the ratio of aliphatic carboxylic acid (B-2) based on the total amount of aliphatic carboxylic acid (B-2) and the alicyclic resin acid (A), is preferably from 0.1 to 70 mass%, particularly preferably from 1 to 60 mass%. However, so long as the relative amount between the alicyclic resin acid (A) and the aliphatic carboxylic acid (B-2) in the polishing composition of the present invention is not inconvenient, an alicyclic resin acid containing more amount of aliphatic carboxylic acid (B-2) may be used. In a case of using an alicyclic resin acid not containing aliphatic resin acid, there is no possibility of occurring such an inconvenience since an aliphatic carboxylic acid (B-2) is used separately.

### OXIDIZER

An oxidizer serves to oxidize a metal such as copper and produces a metallic ion or an oxide although its mechanism is unclear. It is considered that copper ions produced by the reaction of oxidizer, the carboxylic acid (B-1) and the carboxylic acid (B-1a) form a complex to promote polishing.

The oxidizer is preferably a peroxide since it shows strong oxidizing power. An example of peroxide type oxidizer includes an inorganic peroxide such as hydrogen peroxide, a persulfate, a peroxocarbonate, a peroxosulfate or a peroxophosphate, or an organic peroxide such as a benzoyl peroxide, t-butyl hydroperoxide, cumene hydroperoxide, diisopropylbenzene hydroperoxide, performic acid or peracetic acid. A preferred oxidizer is hydrogen peroxide, ammonium persulfate or potassium persulfate. Among these oxidizers, an ammonium salt, particularly ammonium persulfate is preferred since it provides high removal rate of copper film. Next to these oxidizers, hydrogen peroxide or potassium persulfate is preferred. The content of oxidizer based on the polishing composition is preferably at least 0.1 mass%, and if the content is smaller, the removal rate of copper may decrease. If the content of oxidizer is excess, corrosion or dishing of a copper surface tends to occur, and accordingly, the content of oxidizer in the polishing composition is preferably at most 5 mass%. In order to polish a copper film at high removal rate while suppressing dishing, it is preferred to use at least one type of oxidizer of 0.1 to 5 mass% selected from the group consisting of ammonium persulfate, hydrogen peroxide and potassium persulfate. Particularly, from 0.1 to 5 mass% of ammonium persulfate is preferred.

### WATER

The main liquid medium in the polishing composition of the present invention is water, and the liquid medium is preferably water only or a mixture of water and a water-soluble solute. The water is preferably a purified water that is ion-exchanged to remove impurities therefrom. As the water-soluble solute, a water-soluble alcohol, a water-soluble polyol, a water-soluble ester, a water-soluble ether etc. may be used. The liquid medium in the polishing composition of the present invention is preferably water only or a mixed medium of at least 80 mass% of water and a water-soluble organic solute, the most preferably substantially water only. Further, the ratio of liquid medium in the polishing composition of the present invention is at least 90 mass%, particularly preferably at least 95 mass%. Substantially entire amount of the liquid medium is preferably water and in this case, the content of water in the polishing composition of the present invention is at least 90 mass%, particularly preferably at least 95 mass%.

As mentioned above, the percentage of each component in the polishing composition of the present invention means a composition percentage when the composition is used for polishing. In a case where a condensed polishing composition is diluted prior to polishing and the diluted product is used for polishing, the above mentioned and the following percentage of each component means the percentage in the diluted product. A condensed polishing composition is usually diluted by a liquid medium (particularly by water), and accordingly, the relative percentage among components other than the liquid medium usually does not change between before and after the dilution.

The pH value of the polishing composition of the present invention is from 7.5 to 12. When the pH value is lower than 7.5, an alicyclic resin acid (A) contained in the polishing composition of the present invention may be separated in the polishing composition and its distribution may become uneven. In order to polish copper at high speed, it is preferred to make the pH value at least 8.0. If the pH value is 12 or higher, corrosion of copper film becomes significant, such being not preferred. In order to sufficiently suppress unpolished residue or corrosion of copper film, it is preferred to make the pH value 11 or lower. Accordingly, the pH value of the polishing composition of the present invention is preferably from 8.0 to 11.

Further, in the polishing composition of the present invention comprising the alicyclic resin acid (A); another organic carboxylic acid (B) that is a carboxylic acid having a pyridine ring or a quinoline ring; an oxidizer that is at least one type selected from the group consisting of ammonium persulfate, hydrogen peroxide and potassium persulfate; and abrasive particles; the pH value is preferably from 8.0 to 11, particularly preferably from 8.2 to 10.8. If the pH value is lower than 8.2, the alicyclic resin acid (A) contained in the polishing composition of the present invention may be separated in the polishing composition of the present invention and its distribution may become uneven to cause precipitation. If the pH value is higher than 11, corrosion of copper film may occur, and accordingly, in order to sufficiently suppress unpolished residue or corrosion of copper film, the pH value is preferably at most 10.8.

In order to adjust the polishing composition of the present invention to have the above pH value, it is possible to use a pH adjusting agent. In order to adjust the polishing composition to base side, potassium hydroxide, an organic amine or ammonium is preferably employed. Any of these may be employed, but when an organic amine or ammonium that are capable of forming a complex ion with copper is employed, large removal rate of copper film is obtained, such being preferred. Further, in the pH adjustment, the polishing composition may be once adjusted to more basic side than a desired pH value followed by adjusting it towards acidic side by adding nitric acid, sulfuric acid, phosphoric acid etc. to adjust it to the desired pH value.

In the process for preparing the polishing composition of the present invention, the timing of the step for mixing pH adjusting agent is not particularly limited, but when e.g. an alicyclic resin acid (A) not forming a salt is mixed into a liquid medium, it is preferred to mix a pH adjusting agent into the original liquid medium to form a basic liquid medium (which may already contain a part or all of other components) in advance, so that e.g. alicyclic resin acid (A) becomes easily dissolved and mixed in the liquid medium and becomes hardly separated.

### ABRASIVE PARTICLES

The polishing composition of the present invention can exhibit its effect even in a case of not blending abrasive particles, but abrasive particles may be blended into the polishing composition, and in this case, it is possible to polish copper at higher removal rate.

As a type of abrasive particles that may be blended into the polishing composition of the present invention may, for example, be α-alumina, 5-alumina, γ-alumina, a silica or a ceria. Among these, a silica is preferably employed. In a case of employing a silica, from the viewpoint of dispersibility, stability, polishing power etc., a colloidal silica is more preferably employed.

In the case of blending abrasive particles, the average primary particle size of abrasive particles is preferably from 0.005 to 0.5 µm. It is more preferably within a range of from 0.01 to 0.3 µm. The specific surface area of the abrasive particles is preferably from 30 to 300 m²/g. If the specific surface area is less than 30 m²/g, the average primary particle size is too large, and if the specific surface area exceeds 300 m²/g, the primary particle size is too small. When the average primary particle size of the abrasive particles is not too small, sufficient removal rate can be obtained, and when the average primary particle size is not too large, smooth and flat polished surface is obtained. The content of abrasive particles in the polishing composition of the present invention is preferably from 0 to 10 mass%. It is more preferably from 0.05 to 8 mass%, the most preferably from 0.09 to 5 mass%.

### OTHER COMPONENTS

In the polishing composition employed in the polishing method of the present invention, besides the above components, a surfactant, a reducing agent, a viscosity adjusting agent, a dispersing agent, an antiseptic agent etc. may be appropriately blended so long as such blending does not deviate from the purpose of the present invention.

For example, when a surfactant is contained in the polishing composition to be employed in the polishing method of the present invention, the surfactant causes chemical and physical reaction with a copper film surface and provides an effect of protecting the copper film surface although its principle is not unclear. Further, in this case an effect of improving dispersibility of abrasive particles is obtained. Preferred surfactant to be contained in the polishing composition may, for example, be dodecylbenzenesulfonic acid, dodecyl sulfonic acid or these salts, and its preferred content in the polishing composition of the present invention is from 0.01 to 0.2 mass%. As the above salt, a potassium salt or an ammonium slat is preferably employed.

In the polishing composition of the present invention having the above construction, quantitative percentages of its components are preferably such that based on the polishing composition, carboxylic acid is from 0.11 to 8 mass%, the oxidizer is from 0.1 to 5 mass% and water is at least 90 mass%. In the polishing composition having this composition, quantitative percentages of respective carboxylic acids are such that based on the polishing composition, the alicyclic resin acid (A) is 0.01 to 2 mass%, the aliphatic carboxylic acid (B-2) is 0.001 to 0.5 mass% based on the total amount of the polishing composition if the aliphatic carboxylic acid (B-2) is contained, and carboxylic acid(s) in total other than these is preferably from 0.1 to 5 mass%. Here, the carboxylic acid(s) other than these is preferably the carboxylic acid (B-1), particularly preferably the carboxylic acid (B-1a).

Further preferred polishing composition of the present invention contains based on the polishing composition, from 0.01 to 2 mass% of rosin, from 0.1 to 5 mass% of 2-pyridinecarboxylic acid, from 0.1 to 5 mass% of at least one type of oxidizer selected from the group consisting of ammonium persulfate, hydrogen peroxide and potassium persulfate, from 0.01 to 5 mass% of abrasive particles and at least 90 mass% of water, wherein the pH value of the polishing composition is adjusted to be within a range of from 8.0 to 11 by at least one type of base selected from the group consisting of potassium hydroxide, ammonium and an organic amine. Here, the rosin may contain the aliphatic carboxylic acid (B-2), or it may contain no such aliphatic carboxylic acid (B-2). The rosin containing aliphatic carboxylic acid (B-2) is preferably a rosin containing from 10 to 15 mass% of aliphatic resin acid that is an aliphatic carboxylic acid (B-2). Regardless of whether the aliphatic carboxylic acid (B-2) is present in the rosin or not, the polishing composition preferably contains based on the polishing composition, from 0.001 to 0.5 mass% of aliphatic carboxylic acid (B-2), particularly preferably from 0.005 to 0.2 mass%. The aliphatic carboxylic acid (B-2) is preferably at least one type selected from the group consisting of oleic acid, linolic acid, linolenic acid and an alkenylsuccinic acid having total from 14 to 22 carbon atoms. Particularly, oleic acid, linolic acid or a combination thereof is preferred.

The polishing composition having such a construction realizes a flat surface having high precision when it is used for polishing copper used as a metal for wiring. For this reason, it is possible to obtain a semiconductor integrated circuit surface having excellent flat surface state having little dishing or erosion, and thus, the polishing composition is extremely effective for multi-layer wiring and reduction in pattern size in the semiconductor integrated circuit. More specifically, since the polishing composition effectively suppress progress of dishing or erosion in a production process of semiconductor integrated circuit device in which copper wiring is formed by a damascene method, it is possible to obtain a semiconductor integrated circuit surface having excellent and flat surface state.

Still another component may be added to the polishing composition of the present invention to form a polishing agent for use. In this method, change of polishing composition or polishing mechanism according to polishing process become unnecessary in many cases.

### POLISHING COMPOSITION

The polishing composition of the present invention contains an oxidizer, a dissolving agent for metal oxide, an agent for forming protection film and water; and is characterized in that increase of dishing amount is at most 10 nm and that the final dishing amount is at most 20 nm, when the polishing composition is used for polishing a copper layer formed on an insulation layer via a barrier layer to form a pattern in which copper buried wirings of each 100 µm wide and insulation layers of each 100 µm are alternately arranged, and when the polishing composition is used to further polish the copper after the barrier layers adjacent to the copper buried wirings are exposed, at the same removal rate as that before the barrier layers are exposed, for a time required to remove 200 nm of copper before the barrier layers are exposed. By this method, it is possible to realize flat surface of copper used as a metal for wiring with high accuracy.

Here, the dissolving agent for metal oxide corresponds to, in the above explanations, the carboxylic acid (B-1) or the carboxylic acid (B-1a), and the agent for protection film corresponds to, in the explanations, the alicyclic resin acid (A). Further, the polishing composition of the present invention preferably has a pH value of from 7.5 to 12, particularly preferably from 8.5 to 10.5.

It is more preferred that a polishing time at which the increase of dishing amount is at most 10 nm is a polishing time required for removing 400 nm of the copper. Further, the final dishing amount is preferably at most 15 nm, more preferably at most 10 nm.

"When the polishing composition is used for polishing a copper layer formed on an insulation layer via a barrier layer to form a pattern in which copper buried wirings of each 100 µm wide and insulation layers of each 100 µm are alternately arranged, and when the polishing composition is used to further polish the copper after the barrier layers adjacent to the copper buried wirings are exposed, at the same removal rate as that before the barrier layers are exposed, for a time required to remove 200 nm of copper before the barrier layers are exposed" is a condition for obtaining the increase of dishing amount, and does not limit the application of the polishing composition according to the present invention.

The polishing conditions include variable conditions such as removal rate and pressing pressure of polishing pad, but there is no particular limitation to these conditions. Generally speaking, it is preferred to make the removal rate from 200 to 800 nm/min and make the pressing pressure of polishing pad at most 4 psi (which is converted to 27.6 kPa).

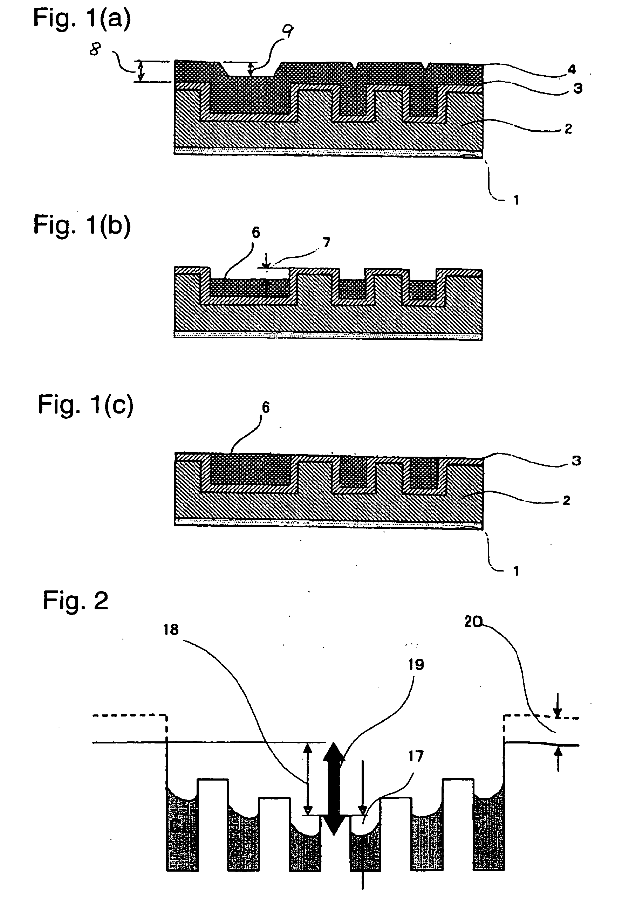

In the above, the dishing amount is the depth indicated by the reference numeral 7 in Fig. 1(b) to be described later. Meanwhile, the increase of dishing amount means the difference (Y-X) between the dishing amount (X) at a time when the barrier layer is exposed and the dishing amount (Y) when the copper is further polished (i.e. over polishing) at a removal rate of copper before the barrier layer is exposed for a time required to polish 200 nm of copper.

In a case of determining whether or not the increase of dishing amount is at most 10 nm or whether or not the final dishing amount is at most 20 nm, it is preferred to carry out several times of testing to obtain the average value.

In the above conditions, the timing when the barrier layers adjacent to the copper-buried wirings are exposed, can be defined as a timing when a part of barrier layer is observed for the first time when actual polishing is carried out and appropriate observation of polishing surface is carried out.

"The removal rate of copper before the barrier layers are exposed" may be actually obtained under the above conditions, but in this step, since presence or absence of pattern does not affect the removal rate of copper, it may also be obtained by using a polishing sample (e.g. a blanket wafer) whose one surface is covered with copper as an alternative. Here, the covering copper in this case is required to be produced under the same conditions as those of the covering copper in the above-described conditions.

The following is a specific example of obtaining increase of dishing amount under the above-conditions. First of all, a polishing sample one surface of which is covered with copper, is used to obtain a time required for polishing 200 nm of copper. This value is assumed to be 30 seconds.

Then, the dishing amount (X) at a time when the barrier layers are exposed, is obtained. X is assumed to be 10 nm. Thereafter, over polishing for 30 seconds is carried out, and the dishing amount (Y) at the end of the over polishing is obtained. Y is assumed to be 17 nm.

In this case, 17 nm - 10 nm = 7 nm is the increase of dishing amount, and the dishing amount at the , completion of over polishing is designated as the final dishing amount.

Here, "the increase of dishing amount when the copper is polished at a removal rate of copper before the barrier layers are exposed for a time required to polish 200 nm of the copper" does not necessarily means the value obtained after the copper is actually polished for the time, but means the incremental speed of dishing amount by over polishing when the over polishing is carried out after the barrier layers adjacent to the copper-buried wirings are exposed. For example, when the time required to polish 200 nm is 50 sec and the increase of dishing amount when the copper is actually polished for 60 sec is 15 nm, the increase of dishing amount converted to the polishing amount by polish of 50 seconds, that is, 15 × (50/60) = 12.5 nm is the increase of dishing amount "when the copper is polished for a time required to polish 200 nm of the copper" according to the present invention.

The polishing composition according to the present invention preferably further contains abrasive particles. When the composition contains abrasive particles, it becomes possible to complete polishing in shorter time.

Further, the polishing composition according to the present invention preferably has a characteristic that the removal rate of copper before the barrier layers are exposed is at least 100 times of the removal rate of the barrier layers. It becomes further easy to realize flat surface with high precision when copper is used as a wiring metal, in many cases.

### POLISHING METHOD

The polishing composition according to the present invention is suitably usable for a polishing method for polishing a copper layer formed on an insulation layer via a barrier layer to form a pattern in which copper-buried wirings and insulation layers are alternately arranged, wherein the method comprises a first polishing step of polishing with a first polishing composition that is the above polishing composition, and a second polishing step that is the subsequent step in the step of polishing the copper layer formed on the insulation layer via the barrier layer to form a pattern in which the copper-buried wirings and the insulation layers are alternately arranged, which is a step of polishing with a second polishing composition whereby the removal rate of copper before the barrier layers are exposed is within a range of from 0.5 to 2 times of the removal rate of the barrier layer, and the removal rate of the insulation layer is within the range of from 0.5 to 2 times of the removal rate of the barrier layer.

By this polishing method in which these two types of polishing compositions are selectively used, it is possible to realize excellent flat surface having little dishing or erosion, with good uniformity in the entire wafer when copper is used as a metal for wiring. Accordingly, this polishing method is extremely effective for multi-layer wiring and reduction of pattern size in semiconductor integrated circuits.

Conditions required for the second polishing composition, specifically, removal rate of copper, removal rate of barrier layer and removal rate of insulation layer may be obtained by using a polishing sample (e.g. a blanket wafer) one surface of which is covered by copper, the same material as the material forming barrier layer or the same material as the material forming insulation layer, in the same manner as the case of obtaining removal rate of copper. However, the covering materials in this case needs to be produced under the same conditions as those of covering materials in the above-described conditions, in the same manner as described above. Whether the conditions satisfy the respective ranges or not, is preferably judged by the averaged values of several times of sampling tests in the same manner as described above.

With respect to the first polishing step and the second polishing step, it is usually preferred that right after the first polishing step, the second polishing step is carried out to complete polishing, but another step may be included between the first polishing step and the second polishing step, before the first polishing step or after the second polishing step. The finish timing of the first polishing step or the start timing or the finish timing of the second polishing step is not particularly limited, and it is appropriately determined depending on the nature of polishing. However, it is usually preferred that the first polishing step is finished at a timing when the copper layer formed on the insulation layer via the barrier layer is removed except in the wirings, the second polishing step is started and the second polishing step is stopped at a timing when a predetermined surface flatness is obtained. Namely, in the first polishing step, copper portions other than the copper wirings are removed, and in the second polishing step, the barrier layer is removed and in most cases, a part of insulation layer and as the case requires, a part of copper is slightly polished to form a flat surface constituted by the insulation layer and the copper layer.

From now, the materials polished in the present invention are described.

### COPPER LAYER

A copper layer is formed on an insulation layer via a barrier layer. Its film-forming method may, for example, be a method of forming a Cu seed layer of about 100 nm thick on a barrier layer by a sputtering method, and further forming a Cu layer on the Cu seed layer by an electrolytic plating method.

### INSULATION LAYER

The insulation layer may be a SiO₂ film formed by a plasma-CVD method using tetraethoxysilane or silane, a low-dielectric material film (e.g. SiOF film or an organic SOG film) or a film having a construction that a cap layer is combined with any of these films.

The material constituting the insulation layer as the object to be polished by the polishing composition of the present invention, may be any one of known films. Silicon dioxide film is an example. As the silicon dioxide film, usually one having a bridging structure of Si and O, in which the ratio of the number of atoms of Si and O is 1:2 is used, but another silicon dioxide film may also be employed. As such a silicon dioxide film, one deposited by a plasma-CVD method by using tetraethoxysilane (TEOS) or silane gas (SiH₄), is commonly known.

Further, in recent years, besides such a silicon dioxide film, a film made of low-dielectric material having a specific dielectric coefficient of at most 3 has become used as an insulation layer for the purpose of suppressing signal delay. As such a low-dielectric material film, a film made of fluorine-added silicon oxide (SiOF), an organic SOG film (a film containing an organic component obtainable by a spin-on-glass method), a low-dielectric material film such as a porous silica film, or an organic silicon material (generally abbreviated as SiOC) film mainly constituted by Si-O bonds and containing CH₃ bonds, are known. These films also may be suitably used as an insulation layer to which the polishing composition according to the present invention is applicable.

The organic silicon material belongs to the extension of existing process technique, and it is expected to be easily applicable to wide range of mass-production techniques by carrying out appropriate process tunings. Accordingly, a technique for flattening a film made of low-dielectric material is desired, and the polishing composition according to the present invention can be suitably used for polishing such a film.

As the organic silicon material being a low-dielectric material, a product name: Black Diamond (specific dielectric coefficient: 2.7, manufactured by APPLIED MATERIALS INC.), product name: Coral (specific dielectric coefficient: 2.7, manufactured by Novellous Systems Inc.) or Aurora 2.7 (specific dielectric coefficient: 2.7, distributed by Japan ASM Inc.) may, for example, be mentioned, and among these, a compound having a Si-CH₃ bond is preferably employed.

The polishing composition according to the present invention can also be suitably used in a case where a cap layer is formed on an insulation layer. For example, in a multi-layer structure in which on a low-dielectric insulation layer, a cap layer, a barrier layer and metal wiring layers are laminated in this order, the polishing composition can be applied in a case of completely removing the cap followed by scraping the insulation layer to achieve flattening.

The cap layer is a layer provided for the purpose of increasing adhesiveness between the insulation layer and the barrier layer in a case of using a low-dielectric material for the insulation layer, or for the purpose of using the cap layer as an etching mask for forming grooves for burring a metal wiring layer in the low-dielectric insulation layer that is chemically mechanically fragile, or for the purpose of preventing quality change of the low-dielectric material.

As such a cap layer, usually a film constituted by silicon and oxygen is used. As such a film, a silicon dioxide film may, for example, be mentioned. As such a silicon dioxide film, usually one having a bridging structure of Si and O wherein the ratio of numbers of Si and O atoms is 1:2, is used, but a film other than this may also be used. As such a silicon dioxide film, one deposited by a plasma CVD method using tetraethoxysilane (TEOS) or a silane gas (SiH₄), is commonly known.

### BARRIER LAYER

A barrier layer is a layer made of e.g. Ta, TaN or TiN formed on the insulation layer by e.g. a sputtering method, and it is disposed for the purpose of preventing diffusion of copper from the copper layer to the insulation layer, but in the present invention, the barrier layer also serves as a stopper for finding a timing when the wiring portion appears in the polishing of copper layer.

According to the present invention, it is possible to realize flattening of a surface with high accuracy when copper is used as a material for wiring. For this reason, it is possible to obtain a semiconductor integrated circuit having excellent and flat surface state having little dishing or erosion, whereby the present invention is extremely effective for multi-layer structure and reduction of pattern size in semiconductor integrated circuits. This feature is described in more detail below.

Generally speaking, in a case of polishing a wafer of large size, since unevenness of film thickness distribution or unevenness of polishing pressure by a pad in the wafer is inevitable, it is difficult to uniformly polish the entire region of the wafer. Accordingly, when a copper layer formed on an insulation layer via a barrier layer is polished to be removed, a barrier layer adjacent to a copper-buried wiring is exposed in a part of the wafer at first. Subsequently, when an overpolishing is carried out to remove a copper film on the barrier layer in the entire region of the wafer, there occurs a problem that dishings of the copper buried wirings sequentially exposed sequentially progress in a polishing process using a conventional polishing agent. Namely, there have been such problems that the dishing amount at a timing when the barrier layer is exposed is large, the dishing amounts become significantly uneven when the first polishing step is completed and excess copper layer is removed by overpolishing, and that erosion also occurs in some cases. For this reason, in the second polishing step, after the barrier layer is removed by polishing, it has been necessary to further remove a part of insulation layer and copper wirings to finish the copper wirings and the insulation layer to be smooth. When the removal amount in the second polishing step is increased, there is a possibility that the depth of wiring groove becomes insufficient in some portion due to uneven polishing in the wafer, or further dishing of copper wirings occurs.

On the other hand, when the polishing composition of the present invention is employed, as described in the above examples, since the initial dishing amount at a timing when the barrier layer is exposed is small and the dishing amount does not substantially increase by overpolishing, it is possible to carry out overpolishing with a margin in the first polishing step without increasing dishing or forming erosion. As a result, even if the copper layer on the barrier layer is removed in the entire wafer, it is possible to suppress the increase of dishing amount due to overpolishing to be within 10 nm in the entire region of the wafer. No erosion occurs in this step. This feature provides an effect that even in a large-sized wafer of at least 8 inches, it is possible to remove excessive copper layer smoothly and uniformly in the entire region of the wafer by overpolishing, and to make the dishing amount at the completion of polishing to be within 20 nm.

Further, since it is not necessary to excessively remove the insulation layer and the copper layer in the second polishing step, it is possible to reduce the thicknesses of the insulation layer and the copper layer and make the trench fabrication shallow, and to reduce the polishing amount. Accordingly, since it is possible to carry out the entire step in shorter time, it is possible to achieve cost down and to obtain a effect of suppressing variation of the depth of grooves for wiring or suppressing dishing of copper wirings.

Further, according to the present invention, it is possible to realize copper wirings with high precision in which decrease of groove depth for wiring (Cu thinning) is suppressed to be within 10 nm, that is required to produce a semiconductor integrated circuit of 50 nm pitch or smaller design rule.

### EXAMPLES

Now, the present invention will be described with reference to Examples. Examples 1 to 10 and Examples 12 to 19 are Examples of the present invention, and Example 11 is a Comparative Example.

The composition of each of polishing compositions of Examples 1 to 19 is shown in Table 1. The content of each component is shown in the unit of mass% based on the total of mixed polishing composition. The content of pH adjusting agent required for obtaining a desired pH value is determined in advance by a separate test using a polishing composition having the same composition. The pH value is measured by using a pH meter (pH 81-11) manufactured by Yokogawa Electric Corporation.

With respect to the polishing composition of each of Examples 1 to 10, first of all, a predetermined amount of 2-pyridinecarboxylic acid (Examples 1 to 3, Examples 5 to 10) or oxalic acid (Example 4), that are the carboxylic acids (B-1) contained in the polishing composition other than the alicyclic resin acid (A), is added to an ion-exchanged water, and subsequently, the above-mentioned content of potassium hydroxide being a pH adjusting agent is added, and they are sufficiently stirred. Further, as the stirring is continued, a potassium salt of rosin being the alicyclic resin acid (A) and a colloidal silica being abrasive particles are added, and subsequently, ammonium persulfate (Examples 1 to 7), potassium persulfate (Example 8, 9) or hydrogen peroxide (Example 10), that are oxidizers, is added to produce the polishing composition.

Here, in each of Examples 9 and 10, a part of potassium hydroxide being a pH adjusting agent is replaced by the amount of ammonium described in Table 1, so that predetermined pH value is obtained by adding these potassium hydroxide and ammonium.

As the potassium salt of rosin being the alicyclic resin acid (A), in Examples 1 to 10, Rosin Soap 30K (product name) manufactured by ARAKAWA CHEMICAL INDUSTRIES, LTD. was used. The Rosin Soap 30K is an aqueous solution containing an aliphatic potassium salt and a rosin potassium salt, wherein the amount of aliphatic potassium salt is about 13 mass% based on the total amount of solid content consisting of the rosin potassium salt and the aliphatic potassium salt, and the main content of the aliphatic potassium salt is potassium salts of linolic acid and oleic acid.

The polishing composition of each of Examples 1 to 5 and Examples 8 to 10 contains abrasive particles made of colloidal silica and having an average primary particle size of 0.02 µm and a specific surface area of 112 m²/g. In Example 6, the polishing composition contains 0.25 mass% of colloidal silica having an average primary particle size of 0.012 µm and a specific surface are of 195 m²/g. In Example 6, the polishing composition contains 0.1 mass% of colloidal silica having an average particle size of 0.03 µm and a specific surface area of 80 m²/g.

Further, in Example 2, the polishing composition also contains as another raw material a dodecylbenzenesulfonic acid being a surfactant that is neutralized by a pH adjusting agent. The amount of pH adjusting agent used for neutralization is included in the amount of pH adjusting agent in Table 1.

The polishing composition of Example 11 was prepared in the same manner as Example 2 except that it contains no alicyclic resin acid (A).

The polishing compositions of Examples 12 to 14 were prepared in the same manner as Example 1 except that potassium dihydroabietate salt, potassium tetrahydroabietate salt and potassium dehydroabietate salt, respectively, were employed instead of Rosin Soap 30K as the alicyclic resin salt.

The polishing composition of Example 15 was produced in the same manner as Example 1 except that SIZEPINE E (product name, manufactured by ARAKAWA CHEMICAL INDUSTRIES, LTD.) that is a rosin partially modified into maleic acid was employed as the alicyclic resin acid. The SIZEPINE E is a maleic-acid-modified product of rosin containing at least about 60 mass% of abietic acid, and the SIZEPINE E contains a fatty acid containing as the main components linolic acid and oleic acid, wherein the amount of fatty acid is about from 10 to 20 mass% based on the total amount of solid content consisting of the rosin and the fatty acid.

The polishing compositions of Examples 16, 17, 18 and 19 were prepared in the same manner as Example 3 except that these polishing compositions employ Vandis T-25K, Vandis E-34K and Vandis G-25K, respectively, as the alicyclic resin acid. Here, in Example 17, the pH value was made to 9.0. The Vandis T-25K and Vandis E-34K are product names of potassium salts of modified product of rosin manufactured by Harima Chemicals Inc. produced by a disproportionation process of tall rosin as the raw material. Vandis T-25 typically contains 50.5 mass% of dehydroabietic acid, 24.9 mass% of dihydroabietic acid, 4.1 mass% of isopimaric acid, 5.2 mass% of isopimaric acid isomer, 2.8 mass% of secodehydroabietic acid, 0 mass% of abietic acid, neoabietic acid and parastrinic acid, and 10.4 mass% of other components as converted as the amount of alicyclic resin acid. Vandis G-25K is a product name of potassium salt of resin manufactured by Harima Chemicals Inc. produced by a disproportionation process of gum rosin as the raw material, and the Vandis G-25K typically contains 62.7 mass% of dehydroabietic acid, 22.6 mass% of dihydroabietic acid, 1.7 mass% of isopimaric acid, 8.9 mass% of isopimaric acid isomer, 0 mass% of secodehydroabietic acid, abietic acid, neoabietic acid and parastrinic acid, and 4.1 mass% of other components as calculated as the amount of alicyclic resin acid.

The polishing property of the polishing compositions were evaluated by the following method.

### OBJECT TO BE POLISHED

As objects to be polished, blanket wafers and patterned wafers were used. As the blanket wafers, 8-inch wafers (manufactured by Sematech Inc., 000CUR015) each having a copper film formed on a Si substrate by a wet plating method, were used for evaluation of copper-removal rate. For tantal-removal rate evaluation, 8-inch wafers (manufactured by Yamaichi) each having a tantal film of 300 nm thick formed on a Si substrate by sputtering, were used.

As the patterned wafer, a 8-inch wafer (product name: 854CMP208) manufactured by Sematech Inc. Fig. 1(a) schematically shows a cross section of the patterned wafer before polishing. This patterned wafer has a construction that on a Si substrate 1, an insulation film made of SiO₂ on which concave portions for burring copper-buried wirings and convex portions are formed, a barrier layer 3 made of a tantal film of 25 nm thick formed by sputtering, and a wiring metal layer 4 made of a copper film of predetermined thickness formed by a wet plating method, are laminated, and wiring patterns of various width from 100 µm to 180 nm are formed. The film thickness of the copper film on a surface of the barrier layer 3 made of tantal on a convex portion of the insulation layer 2 is the initial film thickness 8, and the stepheight between the portions of copper film formed on a convex portion and a concave portion of the insulation layer 2 is the initial stepheight 9.

### EVALUATION OF POLISHING PROPERTY

As a polishing machine, a full-automatic CMP apparatus MIRRA manufactured by APPLIED MATERIALS INC., was used. As a polishing pad, 2-layer pad IC1400 with K-groove (manufactured by Nitta Haars Corp.) was used and its conditioning was carried out by using MEC100-PH3.5L (manufactured by Mitsubishi Materials Corporation).

Polishing was carried out under the conditions that the supply speed of the polishing composition was 200 cm³/min, rotation speeds of the polishing head and a polishing table were 117 rpm and 123 rpm respectively, and the polishing pressure was 1 psi that was 6.89 kPa.

Measurements of copper-removal rate and tantal-removal rate by using blanket wafers, were carried out by using a film-thickness meter RS-75 (manufactured by KLA-Tencor Inc.). Namely, with respect to each of blanket wafers with copper and blanket wafers with tantal, the film thickness before polishing and the film thickness after 1 minute of polishing were measured, and from the difference, the copper-removal rate or the tantal-removal rate (nm/min) was obtained. Further, by dividing the copper-removal rate by the tantal-removal rate, the removal rate ratio (Cu/Ta ratio) between copper and tantal was obtained. Further, the SiO₂ removal rate by using a blanket wafer was measured by using UV1280SE (manufactured by KLA-Tencor Corp.).

Polishing of each patterned wafer was carried out while the endpoint of polishing was monitored by using an optical polishing endpoint detector (manufactured by AMAT, MIRRA ISRM Endpoint Detecting System). Namely, as the polishing progress, the barrier layer made of tantal became exposed, the reflectivity started to drop, and an endpoint was detected when the drop substantially finished and the reflectivity became constant, and thereafter, overpolishing was carried out for 30 sec, 60 sec or 25 sec. At the endpoint of polishing, the copper film on the barrier layer was removed except for a part of entire wafer, and by carrying out overpolishing, the residual copper film in such a portion is removed. The polishing time described in Table 2 to be described later, is a polishing time including such an over polishing time.

After the polishing, with respect to a pattern in which the wiring width and spacing with were each 100 µm, the surface stepheight between a tantal film surface and a copper film surface, namely a dishing amount, was measured by using a profiler HRP-100 apparatus (KLA-Tencor Corp.), to evaluate the degree that the copper wiring pattern surface is concaved from the tantal film surface by polishing. The lower limit of the surface stepheight measurable by this apparatus is 10 nm. The increase of dishing amount was calculated from the dishing amounts of a patterned wafer when overpolishing was carried out for 30 sec, 60 sec or 25 sec.

Fig. 1(a) shows a schematic cross sectional view of a patterned wafer after polishing. In Fig. 1(b), the wiring metal layer 4 made of copper film was completely removed on convex portions of the insulation film 2, and surfaces of the barrier layer 3 made of a tantal film were exposed. Further, on the concave portions of the insulation layer 2, the wiring copper layer 4 was concaved by the amount of reference numeral 7 from the barrier layer 3 surface by polishing. This surface stepheight was designated as a dishing amount 7. On the other hand, Fig. 1(c) is a schematic cross sectional view of a patterned wafer ideally polished, in which copper-buried wirings 6 are formed without forming such a surface step, that is, dishing.

Patterned wafers used for evaluation of polishing with the polishing compositions of Examples 1 and 10 each had a copper film having an initial film thickness of 650 nm and an initial stepheight of 150 nm (Example 1 and 10 in the evaluation result), and the patterned wafers employed for evaluation of polishing with polishing compositions of Examples 2, 3, 4 to 6 and 12 to 15 each had a copper film having an initial film thickness of 550 nm and an initial stepheight of 100 nm that corresponds to pattern grooves (evaluation result of Examples 2, 3a, 4 to 6 and 12 to 15). With respect to the polishing composition of Example 3, polishing evaluation of copper film by using a patterned wafer having an initial film thickness of 800 nm and an initial stepheight of 350 nm, was also carried out (evaluation result of Example 3b). A patterned wafer employed for polishing evaluation of the polishing composition of Example 7 has a copper film having an initial film thickness of 400 nm and an initial stepheight of 80 nm that corresponds to pattern grooves (evaluation result of Example 7), patterned wafers employed for polishing evaluation of the polishing compositions of Examples 8 and 9 each has a copper film having an initial film thickness of 230 nm and an initial stepheight of 50 nm that corresponds to pattern grooves (evaluation results of Examples 8 and 9), a patterned wafer employed for polishing evaluation of the polishing composition of Example 11 has a copper film having an initial film thickness of 1,000 nm and an initial stepheight of 500 nm that corresponds to pattern grooves (evaluation result of Example 11), and patterned wafers employed for polishing evaluation of polishing compositions of Examples 16 to 19 each had a copper film having an initial film thickness of 800 nm and an initial stepheight of 350 nm that corresponds to pattern grooves (evaluation result of Examples 16 to 19).

As evident from the polishing evaluation result of these Examples, by using the polishing composition of the present invention, it is possible to polish a patterned wafer while dishing amount is suppressed. Further, it is also evident that by using the polishing composition of the present invention, the copper removal rate is at least 60 nm/min and that the removal rate ratio between copper and tanal is at least 40 that is sufficiently large, and thus, it is possible to polish a copper film at high speed and to suppress removal of tantal film being a barrier layer.

Particularly, by employing the polishing composition of any one of Examples 1 to 10 or Example 15 in which Losin Soap 30K or SIZEPINE E is employed as the alicyclic resin acid (A), it is possible to polish a patterned wafer while the dishing amount is suppressed to be within 10 nm. Further, by employing a polishing composition of any one of Examples 1 to 7 and Example 15 in which ammonium persulfate is employed as an oxidizer, it is possible to polish a copper at a high removal rate more than 290 nm/min while the dishing amount is suppressed to be within 10 nm.

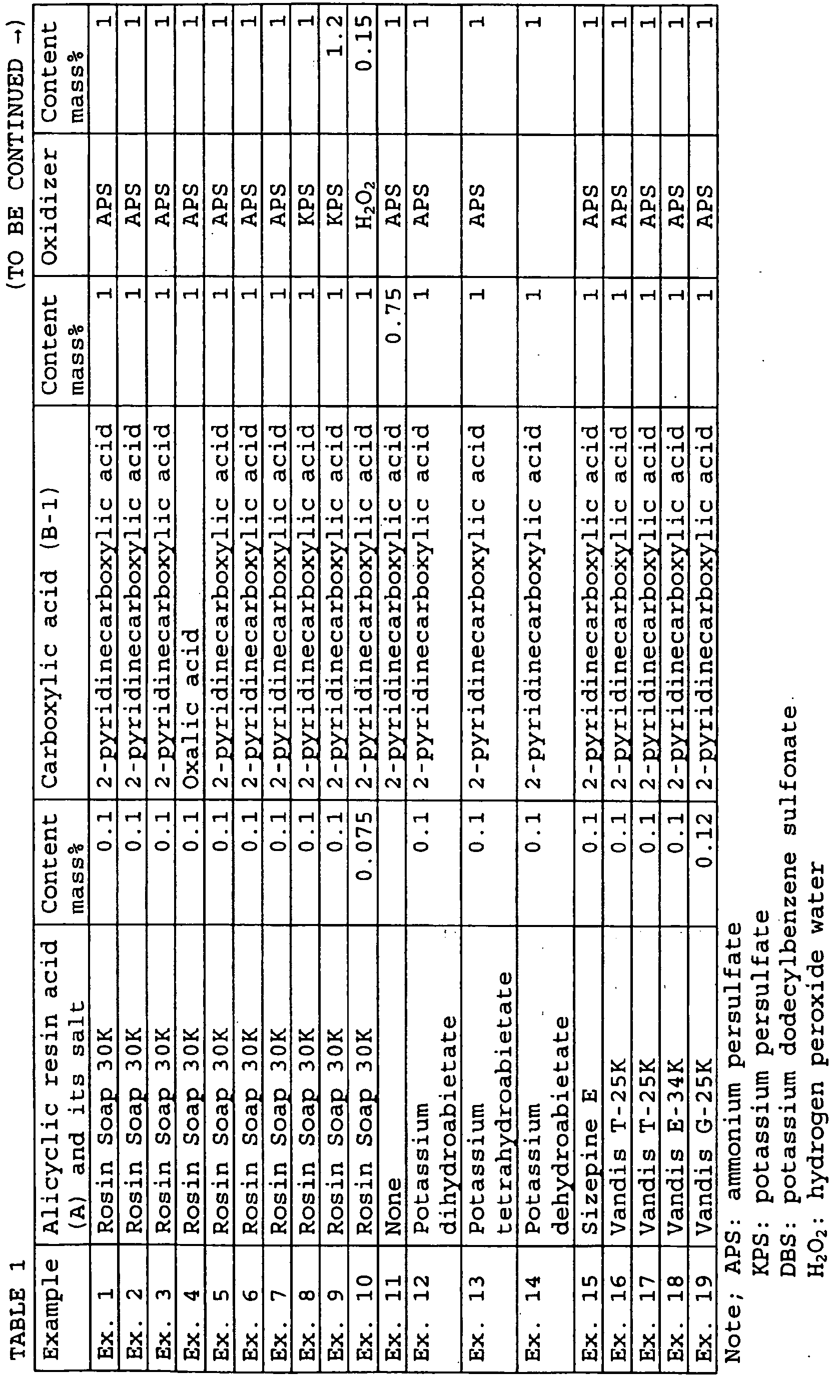

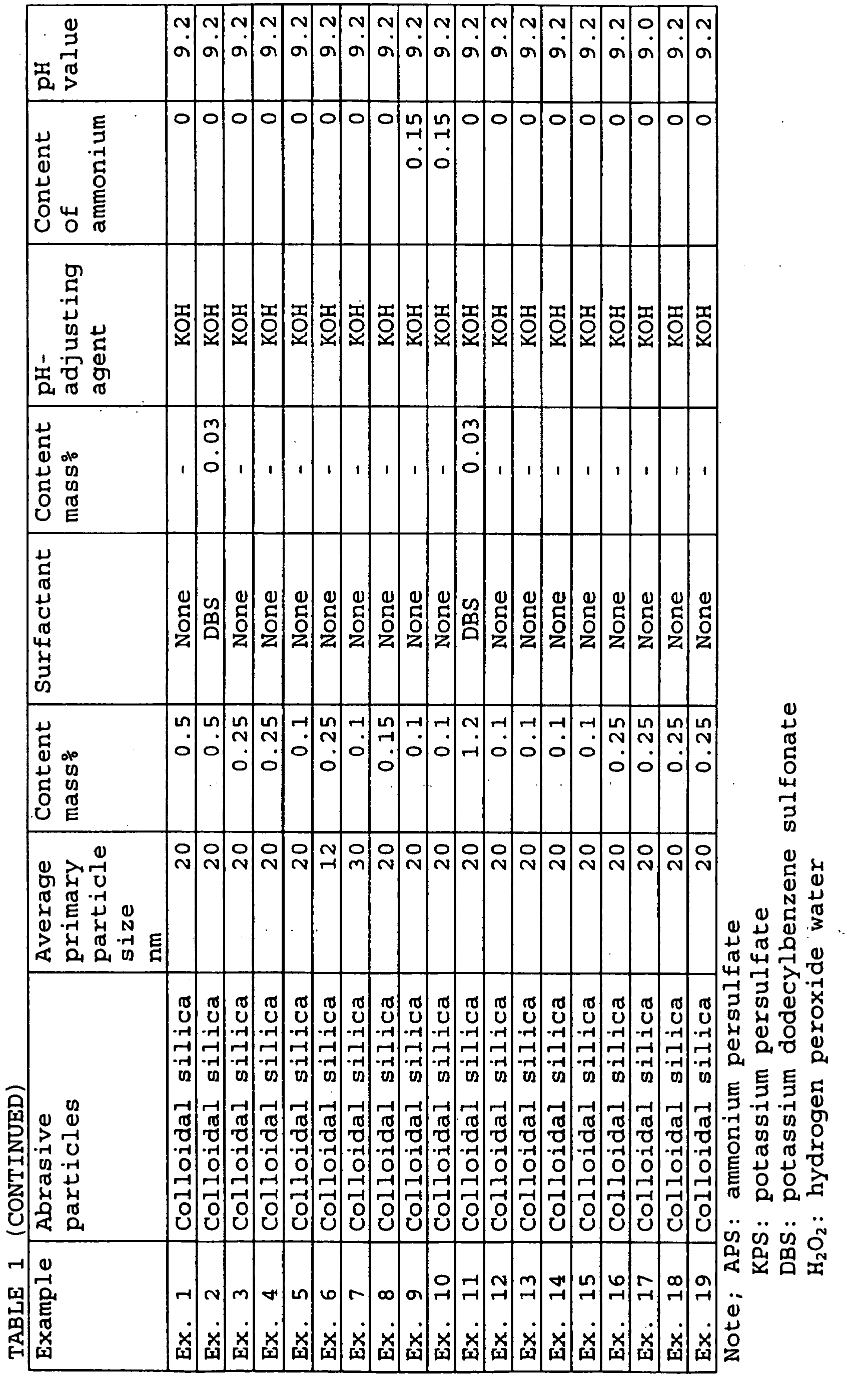

**TABLE 2**

| Example | Copper removal rate (nm/min) | Tantalum removal rate (nm/min) | Cu/Ta ratio | Initial film thickness (nm) | Initial stepheight (nm) | Polishing time (s) | Dishing amount (nm) |
|---|---|---|---|---|---|---|---|
| Ex. 1 | 426 | 2.9 | 147 | 650 | 150 | 135 | <10 |
| Ex. 2 | 353 | - | - | 550 | 100 | 130 | <10 |
| Ex. 3a | 415 | 1.7 | 238 | 550 | 100 | 125 | <10 |
| EX. 3b | 415 | 1.7 | 238 | 900 | 350 | 190 | <10 |
| Ex. 4 | 293 | 6.3 | 46 | 550 | 100 | 152 | <10 |
| Ex. 5 | 413 | 0.6 | 688 | 550 | 100 | 135 | <10 |
| Ex. 6 | 376 | 0.8 | 470 | 550 | 100 | 158 | <10 |
| Ex. 7 | 421 | - 1.2 | 351 | 400 | 80 | 106 | <10 |
| Ex. 8 | 66 | 0.6 | 110 | 230 | 50 | 240 | <10 |
| Ex. 9 | 281 | - | - | 230 | 50 | 70 | <10 |
| Ex. 10 | 351 | - | - | 650 | 150 | 146 | <10 |
| Ex. 11 | 436 | 4.4 | 99 | 1,100 | 500 | 206 | 250 |
| Ex. 12 | 440 | 0.5 | 880 | 550 | 100 | 110 | 35 |
| Ex. 13 | 294 | 0.5 | 588 | 550 | 100 | 160 | 50 |
| Ex. 14 | 359 | 0.5 | 718 | 550 | 100 | 141 | 15 |
| Ex. 15 | 406 | 0.6 | 677 | 550 | 100 | 131 | <10 |
| Ex. 16 | 349 | 1.5 | 233 | 900 | 350 | 230 | 25 |
| Ex. 17 | 300 | - | - | 900 | 350 | 285 | 35 |
| Ex. 18 | 336 | 1.5 | 224 | 900 | 350 | 250 | 40 |
| Ex. 19 | 368 | - | - | 900 | 350 | 199 | 40 |

The compositions, pH values and results of polishing evaluation of polishing compositions of Examples 20 to 32, are summarized in Table 3. In these Examples, the content of 2-pyridinecarboxylic acid being a carboxylic acid (B-1) was 1 mass%; the content of ammonium persulfate being an oxidizer was 1 mass%; the average primary particle size of colloidal silica being abrasive particles was 20 nm, and its content was constantly 0.25 mass%, and no surfactant was contained and thus, description as to surfactant is omitted in the Table. The pH values were adjusted to the pH values described in the Table by using KOH. Here, a content means mass% of a component based on the total amount of polishing composition being a mixed product. A polishing composition in each Example was prepared in the same manner as Example 1 except that the aliphatic carboxylic acid (B-2) was blended at the same time with the alicyclic resin acid (A). The polishing evaluations were carried out in the same manner as those of Examples 1 to 19.

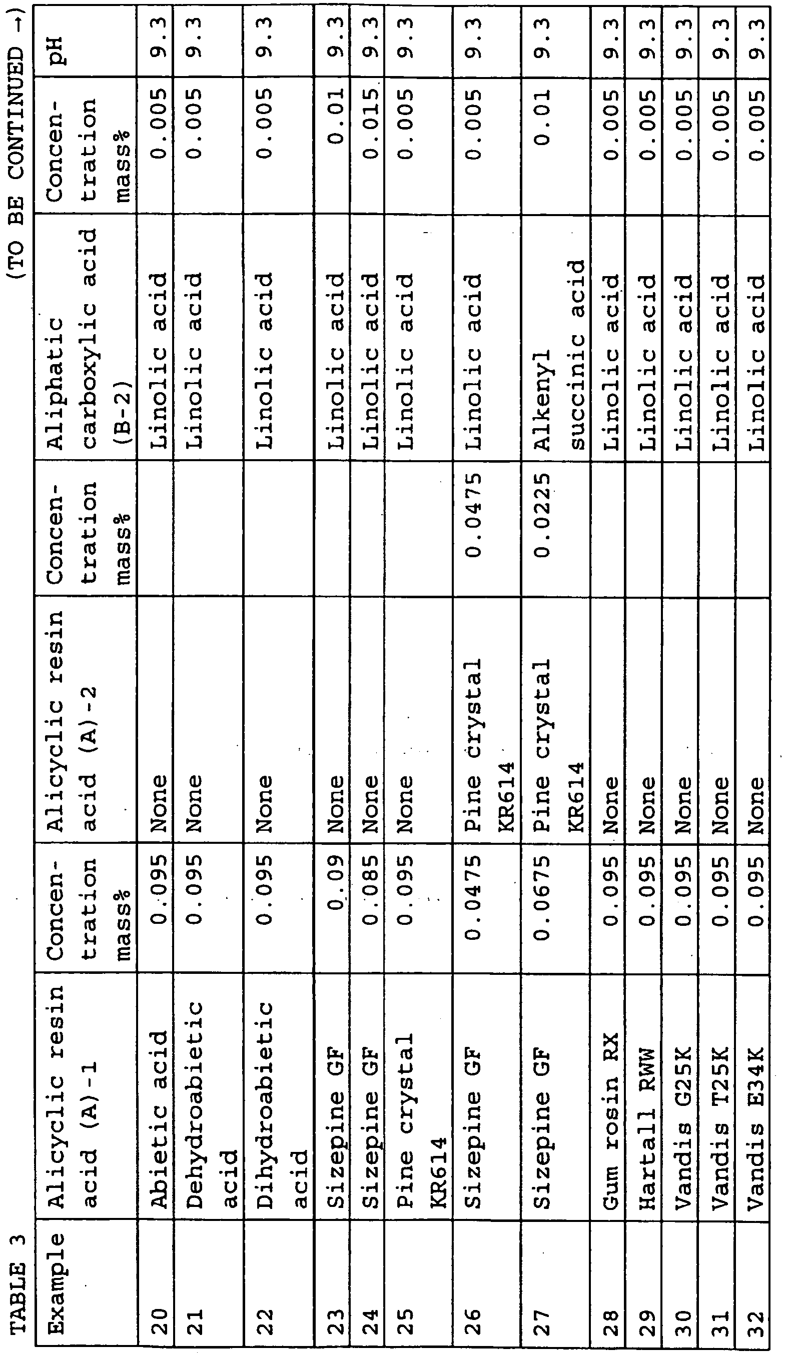

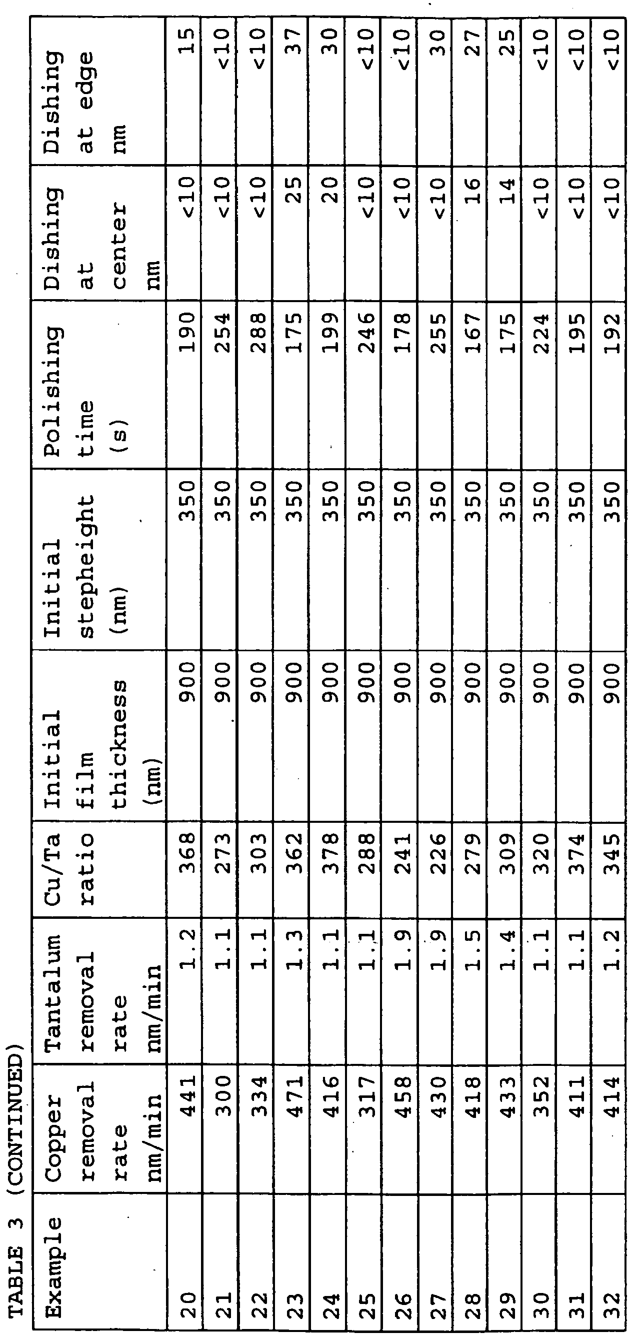

Polishing compositions of Examples 20, 21 and 22 employ as the alicyclic resin acids (A), abietic acid, dehydroabietic acid and dihydroabieteic acid (all manufactured by Wako), respectively, and further contain linolic acid as the aliphatic carboxylic acid (B-2).

Polishing compositions of Examples 33 to 59 have the compositions and pH values summarized in Table 4, and produced in the same manner as Examples 20 to 32. In each of these Examples, the content of 2-pyridinecarboxylic acid being the carboxylic acid (B-1) was 1 mass%; the content of ammonium persulfate being an oxidizer was 1 mass%; the average primary particle size of colloidal silica being abrasive particles was 20 nm and its content was 0.25 mass%; a pH adjusting agent employed was constantly KOH, and the description of pH adjusting agent is omitted in the Table. A content amount means a mass% of component based on the total amount of polishing composition being a mixture. In each of Examples 41 and 42, the polishing composition contained as another raw material, dodecylbenzenesulfonic acid being a surfactant in a state that it was neutralized by a pH adjusting agent. The pH adjusting agent used for neutralization is included in the pH adjusting agent in the Table. Polishing evaluation was carried out in the same manner as those of Examples 1 to 19.

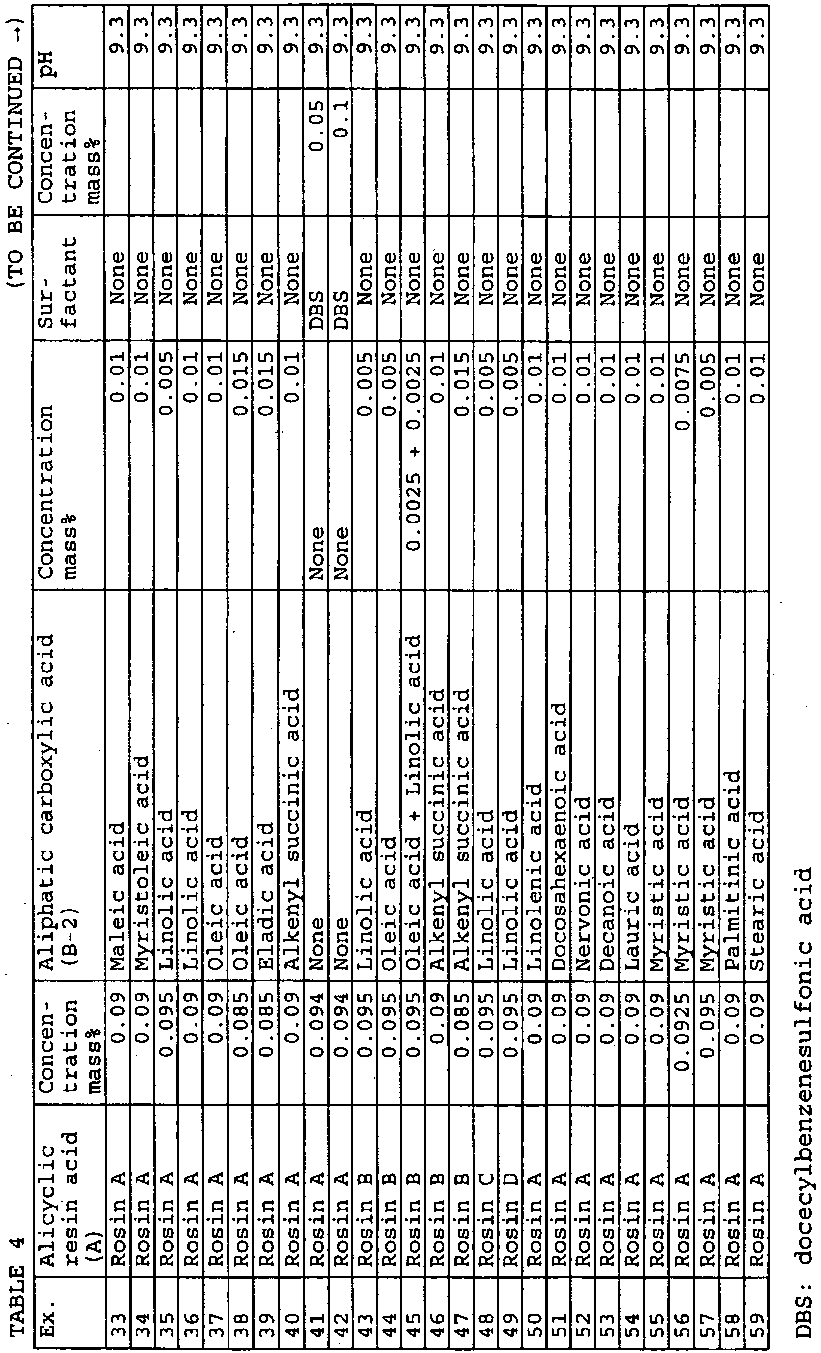

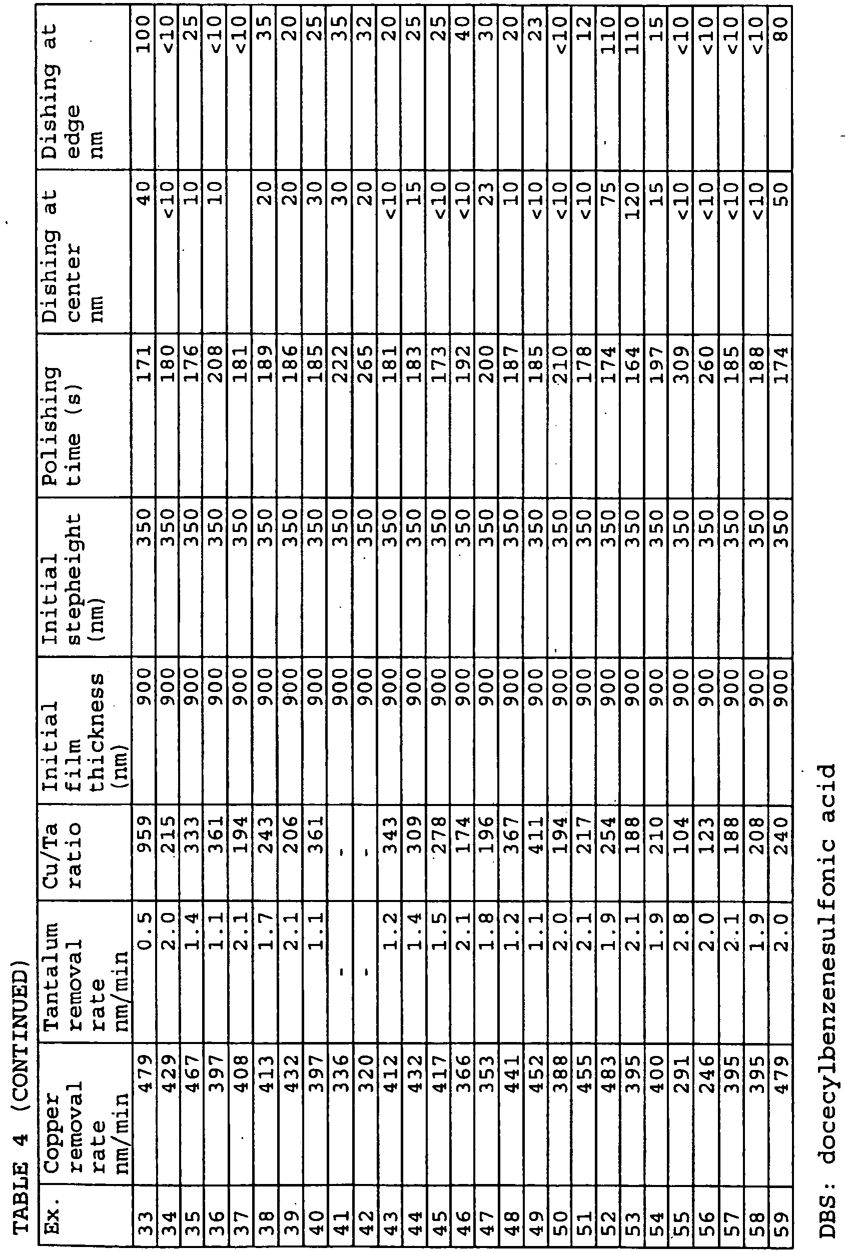

Examples 62 to 72 and Examples 74 and 75 are Examples of the present invention, and Example 73 is a Conventional Example.

The polishing composition of each of the Examples 60 to 75 was prepared in the following manner by using the amount of raw materials shown in Table 5. First of all, a predetermined amount of carboxylic acid (B-1) was added to an ion-exchanged water, and KOH as a pH adjusting agent was added and they were sufficiently stirred. Further, as the stirring was continued, alicyclic resin acid (A), its salt and, as the case requires, aliphatic carboxylic acid (B-2), and further, ammonium persulfate as an oxidizer were added, and colloidal silica as adhesive particles were added to prepare the polishing composition. Here, the content amount described in the Table each means a mass% based on the total amount of polishing composition as a mixture.

Each of the polishing compositions of Examples 60, 61, 65 to 70 and 72 whose aliphatic carboxylic acid (B-2) in Table 5 is noted as "note", employed Pine crystal E or Rosin Soap 30K being an alicyclic resin acid (A) and its salt, respectively, each containing linolic acid and oleic acid that are aliphatic carboxylic acids (B-2).

Further, the content of pH adjusting agent was adjusted so that the polishing composition finally had the pH value described in the Table. In Examples 67 and 69, ammonium (NH₃) and tetramethylammonium hydroxide (TMAH) were employed respectively, as pH adjusting agents instead of KOH, and in Example 70, KOH and 0.4 mass% of ethanolamine were employed, and the composition of these Examples were adjusted so as to have the pH values described in the Table. For the abrasive particles, a colloidal silica having an average primary particle size of 0.02 µm and a specific surface area of 112 m²/g was employed.

In Examples 65 and 73, quinaldic acid was employed as carboxylic acid (B-1), in Examples 66 and 67, glycine was employed as carboxylic acid (B-1), and in Example 68, alanine was employed as carboxylic acid (B-1).

In Example 71, EXTRA OLEIN 90 (product name) manufactured by NOF Corporation and having an oleic acid purity of at least 90%, was contained in a state that it was neutralized by a pH adjusting agent. The pH adjusting agent used for neutralization is included in the pH adjusting agent in Table 1.

In Example 64, ammonium dodecysulfonate (ADS) was employed as a surfactant, and in Examples 72 and 73, dodecylbenzenesulfonic acid was employed as a surfactant.

In Example 68, a polishing composition was prepared in the same manner as Example 4 of JP-A-2002-12854 without containing alicyclic resin acid (A) and its salt.

Table 6 shows evaluation results.

Polishing evaluation of each of Examples 60 to 75 was carried out in the same manner as Examples 1 to 19 except that a patterned wafer was prepared in the following manner.

Patterned wafers employed for polishing evaluation of polishing compositions of Examples 60, 62 to 64, 70, 71, 74 and 75 (Examples 60, 62 to 64, 70, 71a to 71d, 74a, 74b, 75a and 75b in Table 6 of test result), each had a copper film having an initial film thickness of 800 nm and an initial stepheight of 400 nm. Patterned wafers employed for polishing evaluation of the polishing composition of Example 61 (Example 61 in Table 6 of test result) each had a copper film having an initial film thickness of 550 nm and an initial stepheight of 100 nm. Patterned wafers employed for polishing evaluation of the polishing compositions of Examples 65 and 68 (Examples 65 and 68 in Table 6 of test result) each had a copper film having an initial film thickness of 350 nm and an initial stepheight of 100 nm. Patterned wafers employed for polishing evaluation of the polishing composition of Example 66 (Example 66 in Table 6 of test result) each had a copper film having an initial film thickness of 180 nm and an initial stepheight of 55 nm. Patterned wafers employed for polishing evaluation of the polishing compositions of Examples 67 and 69 (Examples 67 and 69 in Table 1 of test results) each had a copper film having an initial film thickness of 500 nm and an initial stepheight of 100 nm that corresponds to pattern grooves. Patterned wafers employed for polishing evaluation of the polishing compositions of Examples 72 and 73 (Examples 72a, 72b, 73a and 73b in Table 6 of test results) each had a copper film having an initial film thickness of 500 nm and an initial stepheight of 80 nm that corresponds to pattern grooves. Further, patterned wafers employed for additional polishing evaluation of the polishing composition of Example 3 (Example 3c in Table 6 of test results) each had a copper film having an initial film thickness of 800 nm and an initial stepheight of 400 nm.

In Table 6, "polishing endpoint" means a polishing time to reach the above mentioned point at which a copper film on a barrier layer is removed except for a part and the barrier layer is exposed", and an overpolishing time means a polishing time after the endpoint. A total polishing time is the total of polishing endpoint and overpolishing time. Measurements of dishing was carried out separately at the central portion (center) and the peripheral portion (edge) in Table 6, a flat rate means a removal rate of a blanket wafer.

An increase of dishing amount is a value converted to an increase of dishing amount produced by polishing a wafer after a barrier layer adjacent to a copper buried wiring is exposed, at a removal rate of copper before the barrier layer is exposed, for a time required to remove 200 nm of copper before the barrier layer is exposed. For example, at central portion of wafers of Examples 73a and 73b, it is (50-48)×(60/25)×(200/256) = 3.8 nm.

Dishing is considered to increase as the polishing time increases. Considering this point, in Examples 71a to 71d, the increase of dishing amount defined in this specification is not considered to be 10 nm or more when the increase of dishing amount is calculated from the difference between a dishing amount at 0 second of overpolishing time and a dishing amount at 30 seconds of overpolishing time, or calculated from the differences among dishing amounts at 0 second, 60 seconds and 120 seconds of overpolishing times.

In Examples 72a and 72b, only dishing amounts at 30 seconds and 60 seconds overpolishing time were evaluated, but since dishing increases as polishing time increases, increase of dishing amount in these cases is not considered to be 10 nm or more. Examples 74a, 74b, 75a and 75b are the same in this respect. On the other hand, in Examples 73a and 73b, the dishing amount is large and its variation is also large already at the endpoint.

In Example 3c, the increase of dishing amount "when a wafer was overpolished at a removal rate of copper before the barrier layer is exposed" for a time required to remove 622 nm of the copper before the barrier layer is exposed, was at most 10 nm, and in Examples 71a to 71d, 72a, 72b, 74a, 74b, 75a and 75b, the increase of dishing amount "when a wafer was overpolished at a removal rate of copper before the barrier layer is exposed" for a time required to remove 128 to 629 nm of the copper before the barrier layer is exposed, was at most 10 nm.

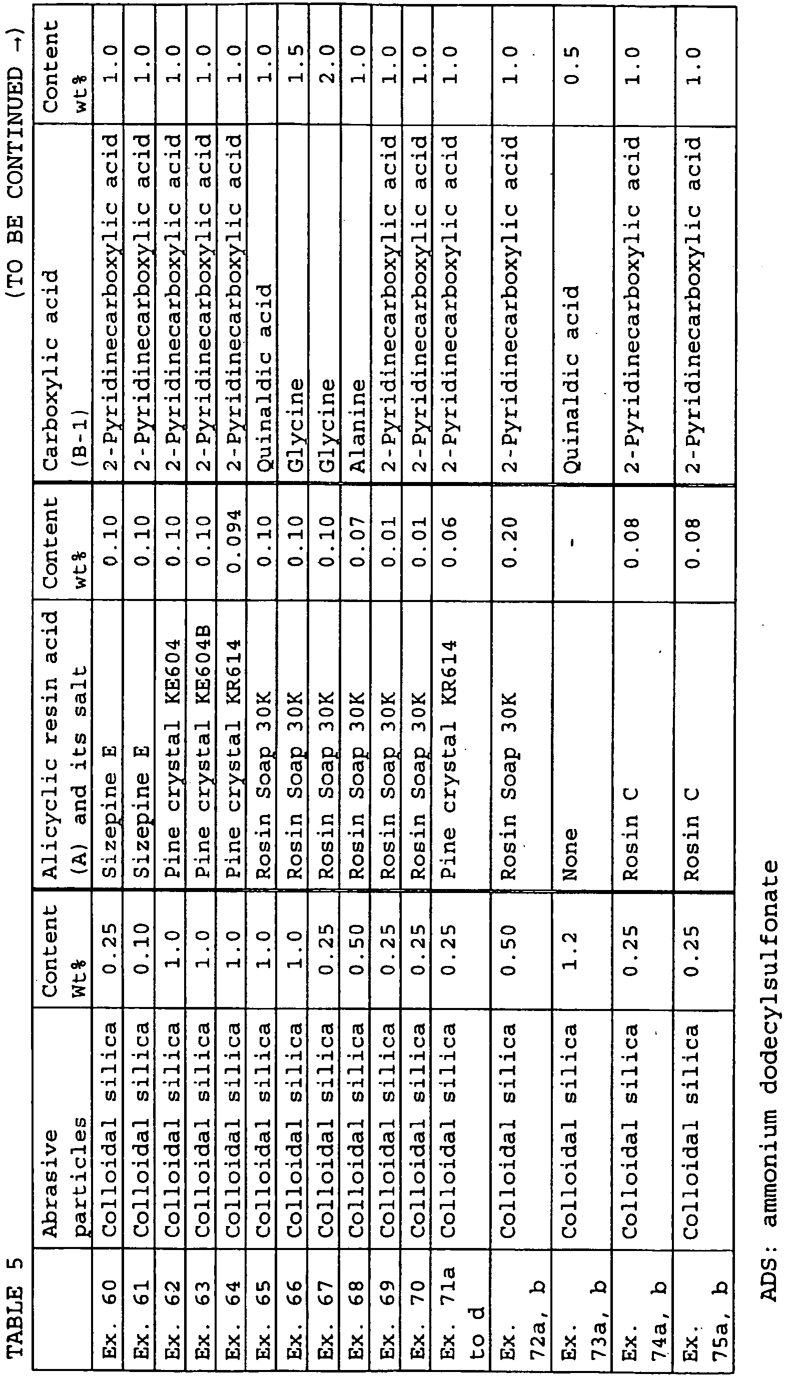

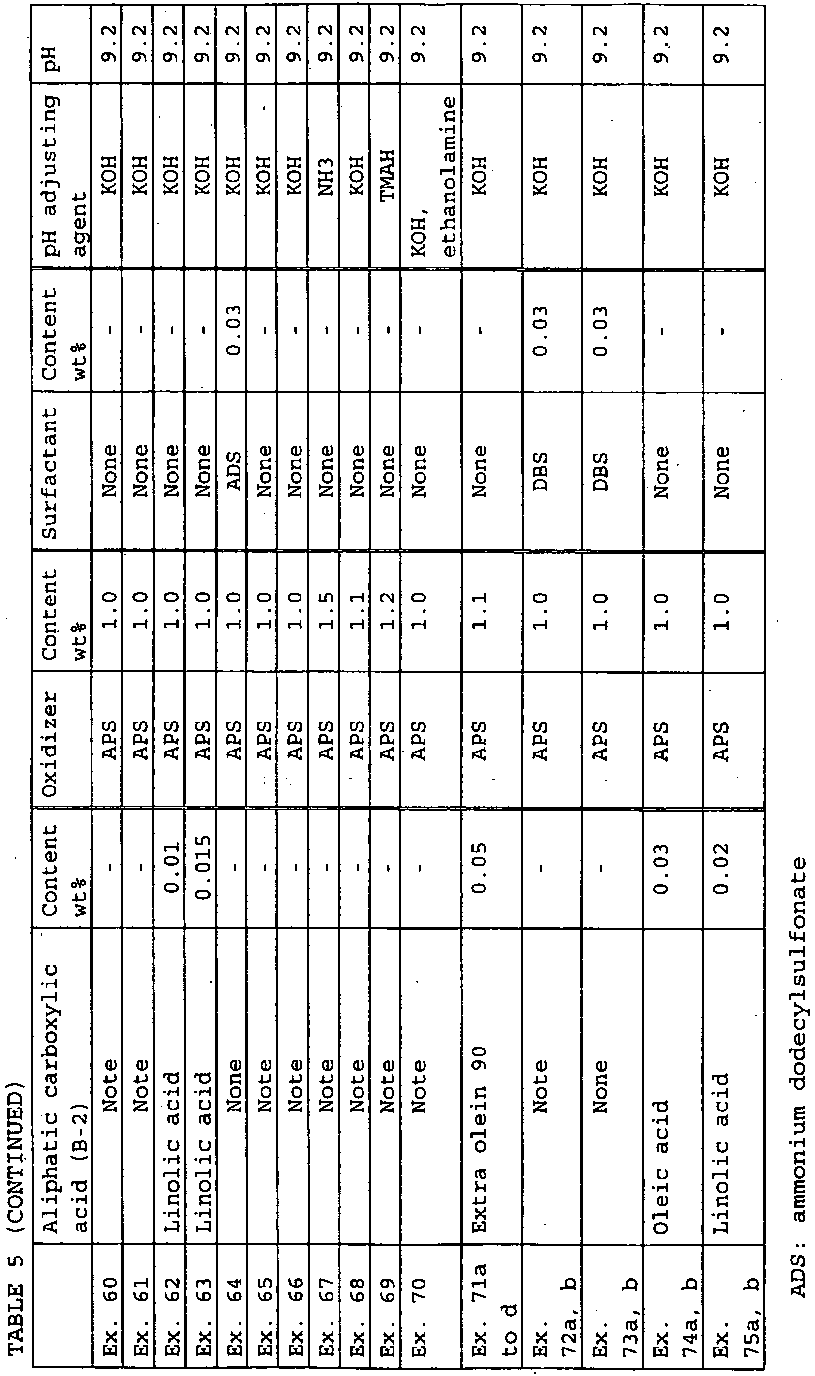

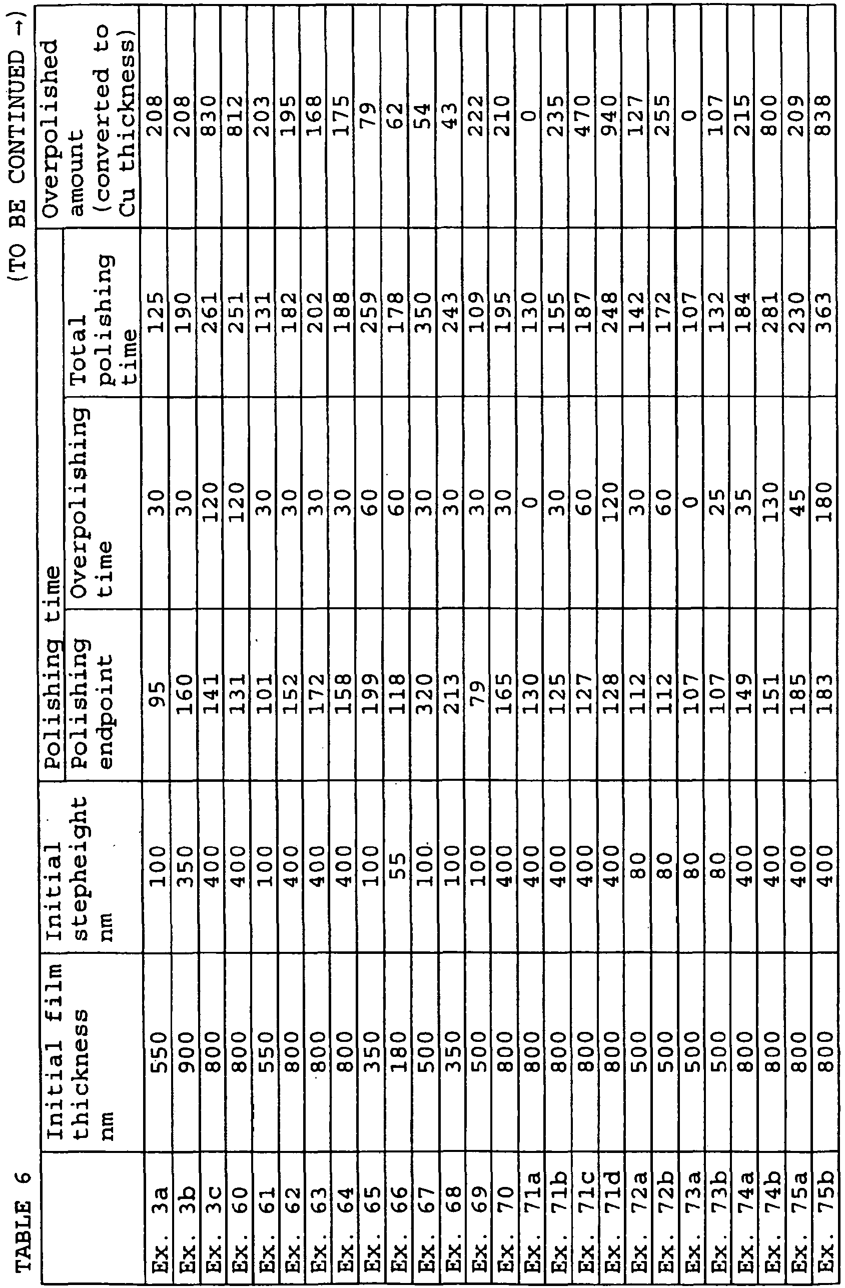

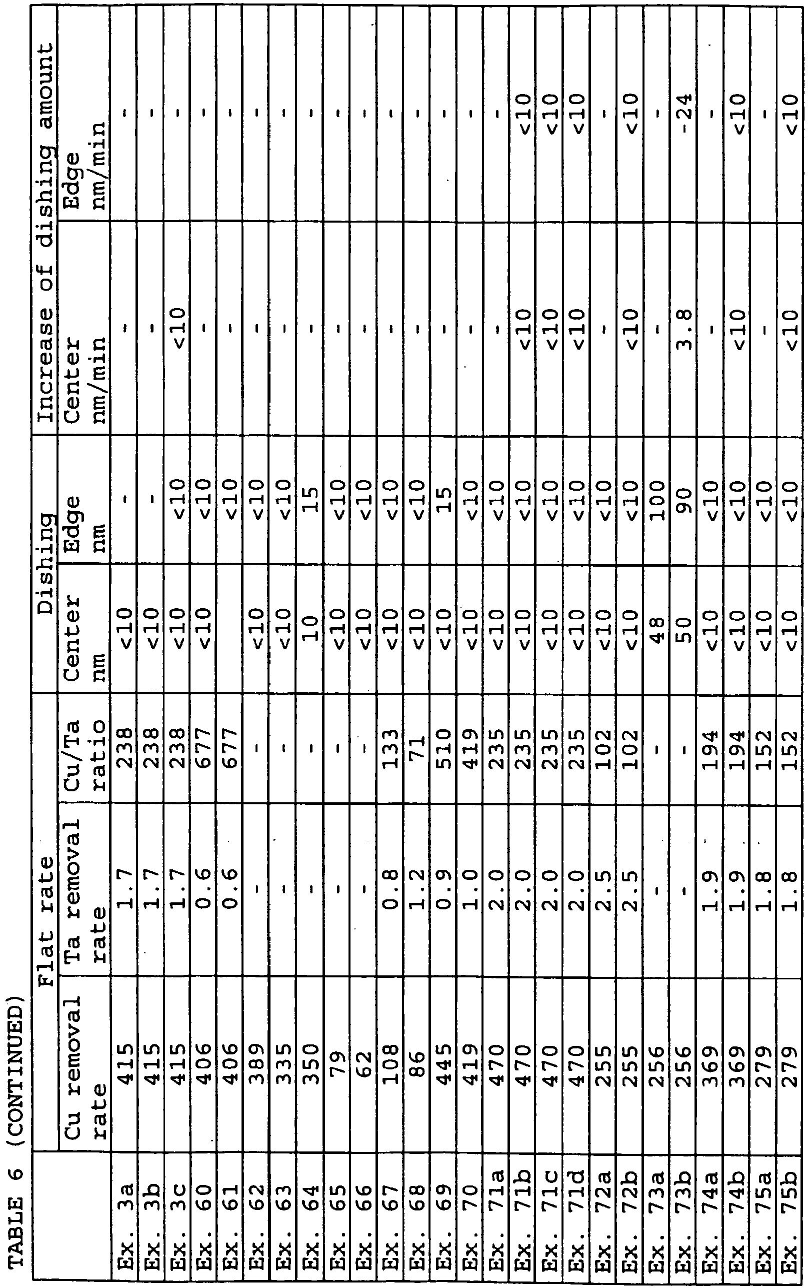

The composition of the alicyclic resin acid (A) was analyzed with respect to samples of plurality of lots by PTAH method by using gas chromatography. Namely, 6 milligram of each sample to be analyzed was dissolved in 0.5 milliliter of PTAH (manufactured by GL Science Inc., Phenyl Trimethyl Ammonium Hydroxide 0.2 mol methanol solution), and put them into a gas chromatography apparatus for which the injection temperature was set to 250°C, so that the sample was instantly turned into methyl ester for measurement. For a column, a capillary column having an inner diameter of 0.25 mm, a length of 25 m and a film thickness of 0.25 µm filled with DEGS, was employed, the oven temperature was set to 180°C, and the injection amount of sample was 4.0 µL. FID was employed for a detector, and from the peak area on the measurement chart obtained, content of each component was obtained.

Table 7 summarizes analysis results of the composition of alicyclic resin acid (A) used in each example. As a result of analysis by the above GC/MS method, it was understood that Rosin Soap 30K contains as main components 45 to 55 mass% of abietic acid and 20 to 25 mass% of dehydroabietic acid, and contains about 13 mass% of potassium salt of fatty acid containing as the main component potassium salts of linolic acid and oleic acid based on the total solid content amount of potassium salt of rosin and potassium salt of fatty acid contained.

Sizepine GF is a product name of modified rosin fumarate made from a gum rosin manufactured by ARAKAWA CHEMICAL INDUSTRIES, LTD. Pine crystal KR614 is a product name of dehydrogened rosin made from a gum rosin manufactured by ARAKAWA CHEMICAL INDUSTRIES, LTD., and it has become clear that its dehydrogenation rate is 80% and contains as the main component 75 to 85 mass% of dehydroabietic acid. For each of the polishing compositions of Examples 26 and 27, two types of alicyclic resin acids that are Sizepine GF and Pine crystal KR614 were employed as a mixture. Gum rosin RX and Hartall RWW employed for the polishing compositions of Examples 28 and 29 respectively, are product names of rosins manufactured by Harima Chemicals Inc. made from gum rosin and tall rosin respectively.

Rosin A is a rosin made from tall rosin. Rosins B-1, B-2 and B-3 are rosins made from gum rosin, and contain abietic acid with a content of about 40 mass%, 50 mass% and 60 mass% respectively. Further, rosins A, B-1, B-2 and B-3 each contains substantially no aliphatic carboxylic acid (B-2).

Pine crystal KE604B employed in Example 62 is an acrylic-acid-modified product manufactured by ARAKAWA CHEMICAL INDUSTRIES, LTD. obtained by modifying a rosin raw material into acrylic acid, which contains partial unreacted rosin. Pine crystal KE604 employed in Example 61 is a modified rosin manufactured by ARAKAWA CHEMICAL INDUSTRIES, LTD. obtained by further hydrogenating the acrylic-acid-modified product.

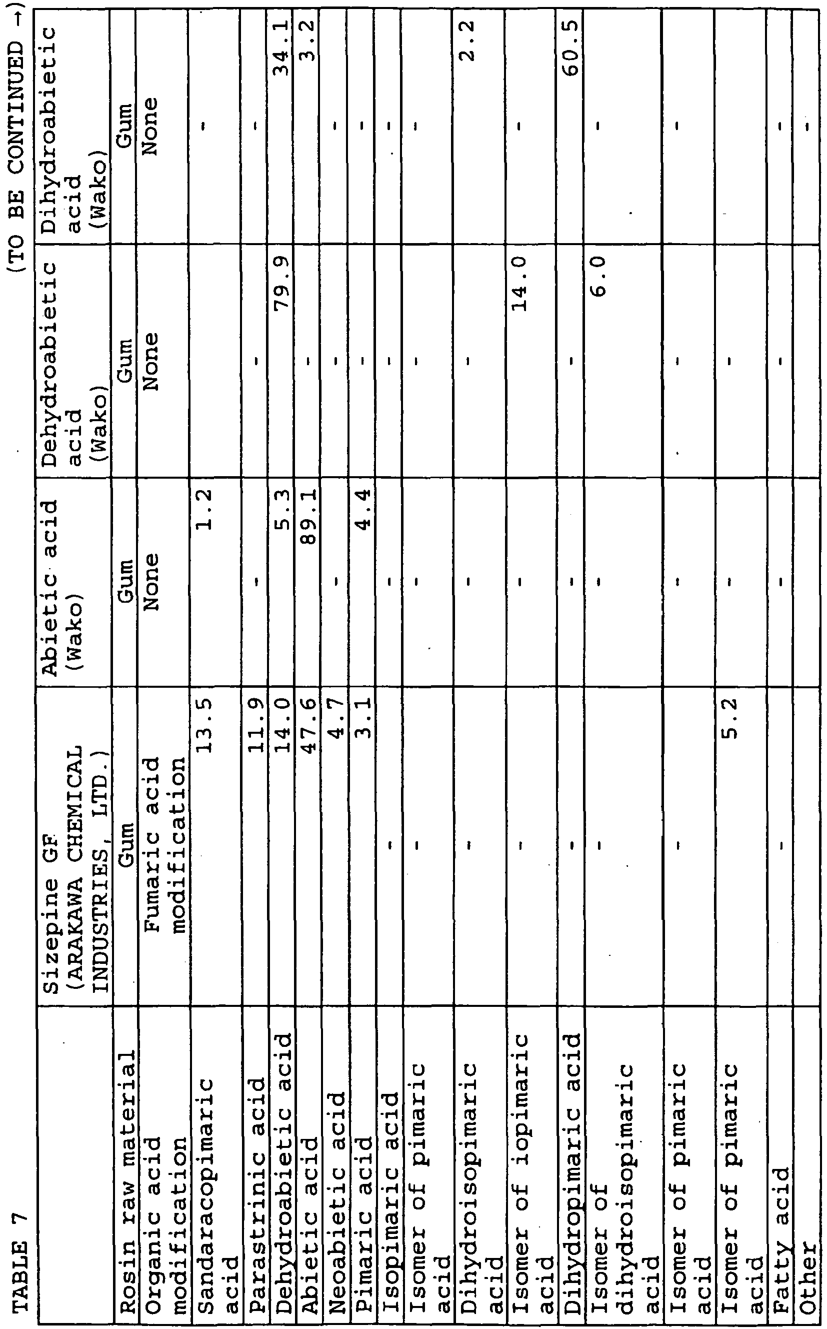

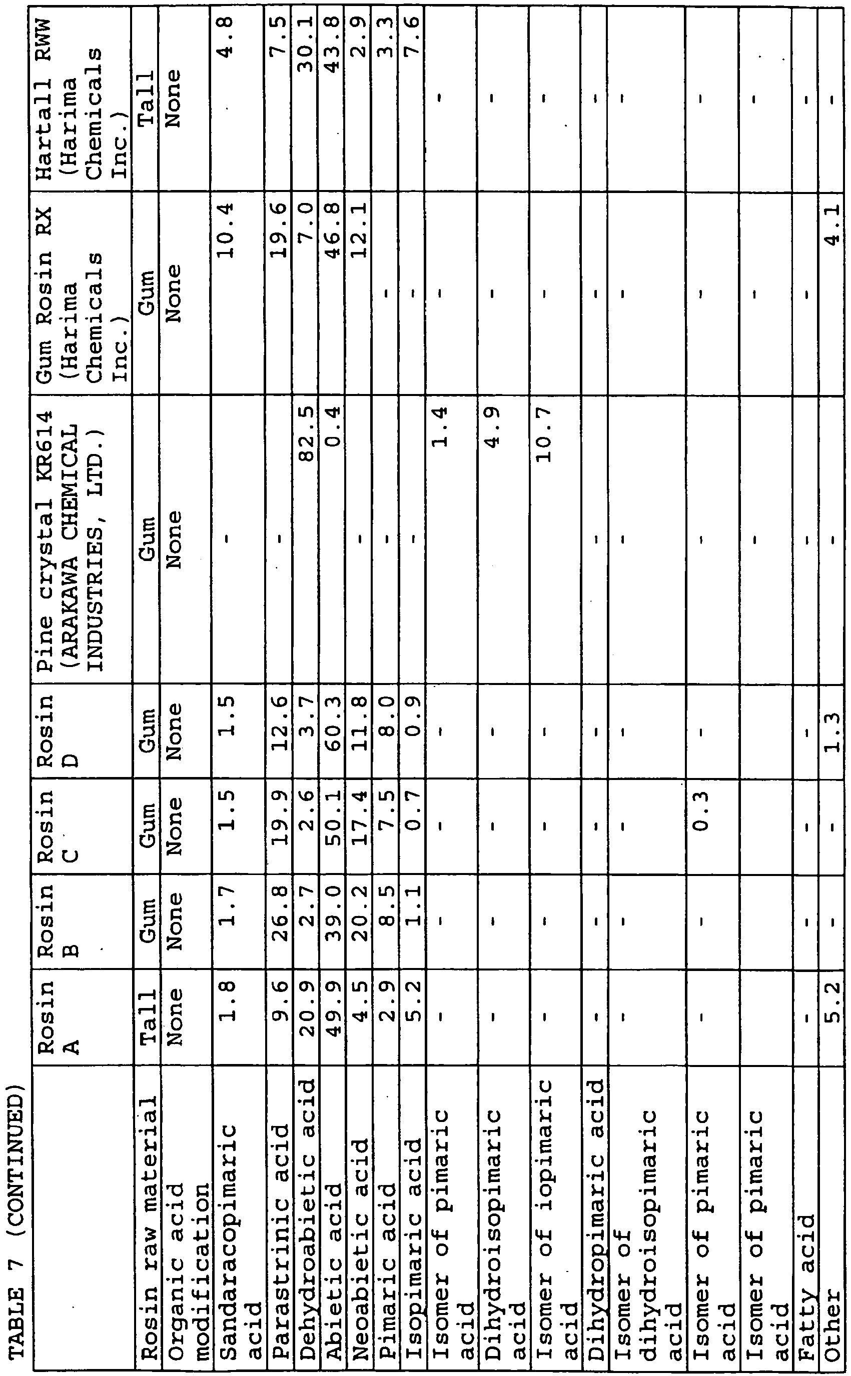

### EXAMPLE 76

This example is an example of polishing method in a patterning step of polishing a copper layer formed on an insulation layer via a barrier layer to form alternately arranged copper-buried wirings and insulation layers, wherein the method comprises a first polishing step of polishing the copper layer formed on the insulation layer via the barrier layer by using the polishing composition of the present invention as a first polishing composition, and a second polishing step to be carried out subsequently to the first polishing step.

A polishing composition for the second polishing step for polishing the barrier layer and the insulation layer was produced in the following manner. Nitric acid, KOH and citric acid were added to a purified water, they were stirred for 10 minutes to obtain an "a" solution. Then, benzotriazole dissolved in ethylene glycol was added to the "a" solution, and pullulan (molecular weight: 2×10⁵) was added to the solution and stirred them for 10 minutes to obtain a "b" solution.

Then, an aqueous dispersed solution of colloidal silica was gradually added to the "b" solution so that the solution had a pH value of pH 2. Further, hydrogen peroxide solution was added to the solution and they were stirred for 30 minutes to obtain a second polishing composition. Here, pullulan is a polysaccharide formed by combining 3 glucose molecules in α-1,4 bond to produce maltotriose and further bonding maltotrioses in α-1,6 bond. The concentrations of these components were such that nitric acid was 0.6 mass%, KOH was 0.5 mass%, citric acid was 0.2 mass%, benzotriazole was 0.1 mass%, ethylene glycol was 1.5 mass%, pullulan was 0.15 mass%, colloidal silica was 5 mass% and hydrogen peroxide was 1.2 mass%.

The polishing conditions at a time of using this second polishing composition were the same as those described above except that IC1400-K-groove (manufactured by NITTA HAAS INCORPORATED) was employed as a polishing pad, the polishing pressure was set to 2 psi that is 14 kPa and the rotation speeds of polishing head and polishing table were 97 rpm and 103 rpm respectively. The removal rates of copper layer, tantal barrier layer and SiO₂ layer on a blanket wafer were 97 nm/min, 72 nm/min and 66 nm/min respectively.

A wafer obtained in Example 71 in which excessive copper layer was removed and a tantal surface was exposed, is polished by using this second polishing composition to remove excessive barrier layer (25 nm thick) on the insulation layer, and further 25 nm of insulation layer is removed, whereby excellent flat surface is obtained in the entire region of the wafer in which the total amount of dishing and erosion after the second polishing step is 10 nm in an isolated wiring portion of 100 µm wide, and the total amount is 10 nm in a 90% density wiring portion in which wiring width is 9 µm and insulation layer width is 1 µm.

Here, erosion tends to occur in a narrow wiring portion or a dense wiring portion, and is a phenomenon that as compared with an insulation layer portion (Global portion) having no wiring pattern, an insulation layer in a wiring portion is excessively removed, whereby the insulation layer partially becomes thin as shown in Fig. 2. Namely, an erosion portion 18 is formed, in which the surface is further removed by polishing than the polished portion 20 of Global portion. Here, in Fig. 2, a barrier layer is omitted.

### INDUSTRIAL APPLICABILITY

The present invention enables to obtain a semiconductor integrated circuit having excellent flat surface state, and is extremely effective for multi-layer structuring and reduction of pattern size of semiconductor integrated circuits. Further, when the polishing composition of the present invention is employed, it is possible to carry out polishing with low pressure while dishing or erosion is suppressed.

## Claims

1. A polishing composition comprising a neutralized carboxylic acid, an oxidizing agent and water, said polishing composition having a pH value of from 7.5 to 12, **characterized in that** a part of said carboxylic acid is an alicyclic resin acid (A).

2. The polishing composition according to Claim 1, wherein the alicyclic resin acid (A) is at least one type of carboxylic acid selected from the group consisting of abietic acid, an isomer of abietic acid, pimaric acid, an isomer of pimaric acid, a rosin and these derivatives.

3. The polishing composition according to Claim 1 or 2, wherein the alicyclic resin acid (A) is neutralized by a basic potassic compound, an ammonium or an organic amine.

4. The polishing composition according to Claim 1, 2 or 3, wherein the other part of the carboxylic acid contains at least one type of carboxylic acid (B-1a) selected from the group consisting of: a polycarboxylic acid having at least two carboxylic groups; and a carboxylic acid having at least one carboxylic group and at least one type of group selected from the group consisting of nitrogen-containing heterocyclic group, amino group a hydroxyl group and thiol group.

5. The polishing composition according to Claim 4, wherein said the other part of the carboxylic group contains besides at least one type of the carboxylic acid (B-1a), an aliphatic carboxylic acid (B-2) containing total at least 11 carbon atoms and having at least one long-chain hydrocarbon group containing at least 8 carbon atoms and at least one carboxylic group.

6. The polishing composition according to Claim 5, wherein the aliphatic carboxylic acid (B-2) is an unsaturated aliphatic carboxylic acid containing total from 12 to 23 carbon atoms and having at least one unsaturated group in its long-chain hydrocarbon portion.

7. The polishing composition according to Claim 5, wherein the aliphatic carboxylic acid (B-2) is a saturated aliphatic carboxylic acid wherein the long-chain hydrocarbon group portion has from 11 to 17 carbon atoms in total.

8. The polishing composition according to any one of Claims 1 to 7, wherein the ratio of the alicyclic resin acid (A) based on the total amount of carboxylic acid is from 0.1 to 70 mass%.

9. The polishing composition according to Claim 5, 6 or 7, wherein the content of the aliphatic carboxylic acid (B-2) is from 0.001 to 0.5 mass% based on the total amount of the polishing composition.

10. The polishing composition according to any one of Claims 1 to 9, which further contains abrasive particles.

11. The polishing composition according to Claim 1, comprising:
from 0.01 to 2 mass% of said alicyclic resin acid (A);
from 0.1 to 5 mass% of at least one type of carboxylic acid (B-1a) selected from the group consisting of a polycarboxylic acid having at least two carboxylic groups, and a carboxylic acid having at least one carboxylic group and at least one type of group selected from the group consisting of a nitrogen-containing heterocyclic group, an amino group, a hydroxyl group and thiol group;
from 0 to 0.5 mass% of aliphatic carboxylic acid (B-2) having a long-chain hydrocarbon group having at least 10 carbon atoms and at least one carboxylic group, and having at least 11 carbon atoms in total;
from 0.1 to 5 mass% of said oxidizing agent ; and
at least 90 mass% of water;
wherein the alicyclic resin acid (A), the carboxylic acid (B-1a) and the aliphatic carboxylic acid (B-2) are neutralized, and the polishing composition has a pH value of from 8.0 to 11.

12. A method for producing a copper wiring for a semiconductor integrated circuit, which comprises polishing a copper film for wiring formed on a surface having grooves by using the polishing composition as defined in any one of Claims 1 to 11.

## Patentansprüche

1. Polierzusammensetzung, umfassend eine neutralisierte Carbonsäure, ein Oxidationsmittel und Wasser, wobei die Polierzusammensetzung einen pH-Wert von 7,5 bis 12 aufweist, **dadurch gekennzeichnet, daß** ein Teil der Carbonsäure eine alicyclische Harzsäure (A) ist.

2. Polierzusammensetzung gemäß Anspruch 1, wobei die alicyclische Harzsäure (A) mindestens ein Typ von Carbonsäure, ausgewählt aus der Gruppe, bestehend aus Abietinsäure,. einem Isomer von Abietinsäure, Pimarsäure, einem Isomer von Pimarsäure, einem Terpentinharz und dessen Derivaten, ist.

3. Polierzusammensetzung gemäß Anspruch 1 oder 2, wobei die alicyclische Harzsäure (A) durch eine basische Kaliumverbindung, ein Ammonium oder ein organisches Amin neutralisiert ist.

4. Polierzusammensetzung gemäß Anspruch 1, 2 oder 3, wobei der andere Teil der Carbonsäure mindestens einen Typ von Carbonsäure (B-1a), ausgewählt aus der Gruppe, bestehend aus: einer Polycarbonsäure mit mindestens zwei Carbonsäuregruppen und einer Carbonsäure mit mindestens einer Carbonsäuregruppe und mindestens einem Typ einer Gruppe, ausgewählt aus der Gruppe, bestehend aus einer stickstoffhaltigen heterocyclischen Gruppe, einer Aminogruppe, einer Hydroxylgruppe und einer Thiolgruppe, enthält.

5. Polierzusammensetzung gemäß Anspruch 4, wobei der andere Teil der Carbonsäuregruppe neben mindestens einem Typ der Carbonsäure (B-1a) eine aliphatische Carbonsäure (B-2), enthaltend im gesamten mindestens 11 Kohlenstoffatome und mindestens eine langkettige Kohlenwasserstoffgruppe enthaltend mindestens 8 Kohlenstoffatome und mindestens eine Carbonsäuregruppe aufweisend, enthält.

6. Polierzusammensetzung gemäß Anspruch 5, wobei die aliphatische Carbonsäure (B-2) eine ungesättigte aliphatische Carbonsäure, enthaltend im gesamten von 12 bis 23 Kohlenstoffatome und mindestens eine ungesättigte Gruppe in dessen langkettigem Kohlenwasserstoffteil aufweisend, ist.

7. Polierzusammensetzung gemäß Anspruch 5, wobei die aliphatische Carbonsäure (B-2) eine gesättigte aliphatische Carbonsäure ist, wobei der langkettige Kohlenwasserstoffgruppenteil von 11 bis 17 Kohlenstoffatomen im Gesamten aufweist.

8. Polierzusammensetzung gemäß einem der Ansprüche 1 bis 7, wobei das Verhältnis der Säure eines alicyclischen Harzes (A) bezogen auf die Gesamtmenge an Carbonsäure von 0,1 bis 70 Masse-% beträgt.

9. Polierzusammensetzung gemäß Anspruch 5, 6 oder 7, wobei der Anteil der aliphatischen Carbonsäure (B-2) von 0,001 bis 0,5 Masse-% bezogen auf die Gesamtmenge der Polierzusammensetzung beträgt.

10. Polierzusammensetzung gemäß einem der Ansprüche 1 bis 9, welche weiter abrasive Teilchen enthält.

11. Polierzusammensetzung gemäß Anspruch 1, umfassend:
von 0,01 bis 2 Masse-% der alicyclischen Harzsäure (A),
von 0,1 bis 5 Masse-% von mindestens einem Typ von Carbonsäure (B-1a), ausgewählt aus der Gruppe, bestehend aus einer Polycarbonsäure mit mindestens zwei Carbonsäuregruppen und einer Carbonsäure mit mindestens einer Carbonsäuregruppe und mindestens einem Typ einer Gruppe, ausgewählt aus der Gruppe, bestehend aus einer stickstoffhaltigen heterocyclischen Gruppe, einer Aminogruppe, einer Hydroxylgruppe und einer Thiolgruppe,
von 0 bis 0,5 Masse-% einer aliphatischen Carbonsäure (B-2) mit einer langkettigen Kohlenwasserstoffgruppe mit mindestens 10 Kohlenstoffatomen und mindestens einer Carbonsäuregruppe und mindestens 11 Kohlenstoffatome im Gesamten aufweisend,
von 0,1 bis 5 Masse-% des Oxidationsmittels und mindestens 90 Masse-% Wasser,
wobei die alicyclische Harzsäure (A), die Carbonsäure (B-1a) und die aliphatische Carbonsäure (B-2) neutralisiert sind und die Polierzusammensetzung einen pH-Wert von 8,0 bis 11 aufweist.

12. Verfahren zur Herstellung einer Kupferverdrahtung für einen integrierten Halbleiterschaltkreis, welches das Polieren eines Kupferfilms zur Verdrahtung gebildet auf einer Oberfläche mit Gruben durch Verwendung der Polierzusammensetzung, wie in einem der Ansprüche 1 bis 11 definiert, umfaßt.

## Revendications

1. Composition de polissage comprenant un acide carboxylique neutralisé, un agent oxydant et de l'eau, ladite composition de polissage présentant une valeur de pH de 7,5 à 12, **caractérisée en ce qu'**une partie dudit acide carboxylique est un acide de résine alicyclique (A).

2. Composition de polissage selon la revendication 1, dans laquelle l'acide de résine alicyclique (A) est au moins un type d'acide carboxylique choisi dans l'ensemble constitué par l'acide abiétique, un isomère d'acide abiétique, l'acide pimarique, un isomère d'acide pimarique, une colophane et leurs dérivés.

3. Composition de polissage selon la revendication 1 ou 2, dans laquelle l'acide de résine alicyclique (A) est neutralisé par un composé potassique basique, un ammonium ou une amine organique.

4. Composition de polissage selon la revendication 1, 2 ou 3, dans laquelle l'autre partie de l'acide carboxylique contient au moins un type d'acide carboxylique (B-1a) choisi dans l'ensemble constitué par un acide polycarboxylique comportant au moins deux groupes carboxyliques ; et un acide carboxylique comportant au moins un groupe carboxylique et au moins un type de groupe choisi dans l'ensemble constitué par un groupe hétérocyclique azoté, un groupe amino, un groupe hydroxyle et un groupe thiol.

5. Composition de polissage selon la revendication 4, dans laquelle ladite autre partie du groupe carboxylique contient, mis à part au moins un type de l'acide carboxylique (B-1a), un acide carboxylique aliphatique (B-2) contenant au total au moins 11 atomes de carbone et comportant au moins un groupe hydrocarboné à longue chaîne contenant au moins 8 atomes de carbone et au moins un groupe carboxylique.

6. Composition de polissage selon la revendication 5, dans laquelle l'acide carboxylique aliphatique (B-2) est un acide carboxylique aliphatique insaturé contenant au total de 12 à 23 atomes de carbone et comportant au moins un groupe insaturé dans sa portion hydrocarbonée à longue chaîne.

7. Composition de polissage selon la revendication 5, dans laquelle l'acide carboxylique aliphatique (B-2) est un acide carboxylique aliphatique saturé dans lequel la portion de groupe hydrocarboné à longue chaîne comporte de 11 à 17 atomes de carbone au total.

8. Composition de polissage selon l'une quelconque des revendications 1 à 7, dans laquelle la proportion de l'acide de résine alicyclique (A) par rapport à la quantité totale d'acide carboxylique est de 0,1 à 70 % en masse.

9. Composition de polissage selon la revendication 5, 6 ou 7, dans laquelle la teneur en l'acide carboxylique aliphatique (B-2) est de 0,001 à 0,5 % en masse par rapport à la quantité totale de la composition de polissage.

10. Composition de polissage selon l'une quelconque des revendications 1 à 9, qui contient en outre des particules abrasives.

11. Composition de polissage selon la revendication 1, comprenant :
de 0,01 à 2 % en masse dudit acide de résine alicyclique (A) ;
de 0,1 à 5 % en masse d'au moins un type d'acide carboxylique (B-1a) choisi dans l'ensemble constitué par un acide polycarboxylique comportant au moins deux groupes carboxyliques, et un acide carboxylique comportant au moins un groupe carboxylique et au moins un type de groupe choisi dans l'ensemble constitué par un groupe hétérocyclique azoté, un groupe amino, un groupe hydroxyle et un groupe thiol ;
de 0 à 0,5 % en masse d'acide carboxylique aliphatique (B-2) comportant un groupe hydrocarboné à longue chaîne comportant au moins 10 atomes de carbone et au moins un groupe carboxylique, et comportant au moins 11 atomes de carbone au total ;
de 0,1 à 5 % en masse dudit agent oxydant ; et
au moins 90 % en masse d'eau ;
dans laquelle l'acide de résine alicyclique (A), l'acide carboxylique (B-1a) et l'acide carboxylique aliphatique (B-2) sont neutralisés, laquelle composition de polissage présente une valeur de pH de 8,0 à 11.

12. Procédé pour produire un câblage en cuivre pour un circuit intégré à semi-conducteur, qui comprend le polissage d'un film de cuivre pour câblage formé sur une surface comportant des rainures, par utilisation de la composition de polissage telle que définie dans l'une quelconque des revendications 1 à 11.
